# EUROPEAN PATENT SPECIFICATION

(11) **EP 4 071 838 B1**
(45) Date of publication and mention of the grant of the patent: **21.05.2025**
(21) Application number: 22166104.4
(22) Date of filing: 31.03.2022
(51) Int. Cl.: H10H 29/01, H10H 29/32, H10H 29/49, H10H 29/03, H10H 29/80

(54) **DISPLAY DEVICE AND MANUFACTURING METHOD THEREOF**
ANZEIGEVORRICHTUNG UND HERSTELLUNGSVERFAHREN DAFÜR
AFFICHEUR ET SON PROCÉDÉ DE FABRICATION

(30) Priority: 06.04.2021 KR 20210044823
(43) Date of publication of application: 12.10.2022
(73) Proprietor: Samsung Display Co., Ltd., Yongin-si, Gyeonggi-do 17113 (KR)
(72) Inventor: PARK, Jeong Su, 17113 Yongin-si (KR); KIM, Hyun, 17113 Yongin-si (KR); SONG, Myeong Hun, 17113 Yongin-si (KR); WANG, Jeong Kook, 17113 Yongin-si (KR); LEE, Jong Chan, 17113 Yongin-si (KR); CHO, Yong Tae, 17113 Yongin-si (KR)
(74) Representative: Taor, Simon Edward William

(56) References cited:
- US-A1- 2016 118 543
- US-A1- 2020 013 766
- US-A1- 2020 161 499
- US-A1- 2020 176 656

## Description

### CROSS-REFERENCE TO RELATED APPLICATION

This application claims priority to and the benefit of Korean Patent Application No. 10-2021-0044823 filed in the Korean Intellectual Property Office on April 6, 2021.

### BACKGROUND

### 1. Field

The present disclosure relates to a display device and a manufacturing method thereof.

### 2. Description of the Related Art

As interest in display devices is increasing research and development for the display devices are continuously conducted. US2020/0161499 discloses an LED, a manufacturing method thereof and a display device. US2016/0118543 discloses a light emitting device. US2020/176656 A1 discloses a display device, and a corresponding manufacturing method which are close to the present invention.

### SUMMARY

The present invention provides a display device and a manufacturing method thereof that may simplify a manufacturing process of the display device by reducing the number of masks.

According to the present invention, because connecting electrodes are separated by side protrusions and depressions of a second insulating pattern, even if the connecting electrodes are formed at the same time, a short circuit between the connecting electrodes may be reduced or prevented. Accordingly, it is possible to reduce the number of masks and simplify a manufacturing process of a display device.

According to an aspect, there is provided a display device as set out in claim 1. Additional features are set out in claims 2 to 10. According to an aspect, there is provided a method as set out in claim 11. Additional features are set out in claims 12 to 14.

Aspects of embodiments of the present disclosure are not limited by what is illustrated in the above, and more various aspects are included in the present specification.

### BRIEF DESCRIPTION OF THE DRAWINGS

FIG. 1 and FIG. 2 illustrate a perspective view and a cross-sectional view of a light emitting element according to one or more embodiments, respectively.
FIG. 3 illustrates a top plan view of a display device according to one or more embodiments.
FIG. 4 illustrates a circuit diagram of a pixel according to one or more embodiments.
FIG. 5 illustrates a top plan view of a pixel according to one or more embodiments.
FIG. 6 illustrates a cross-sectional view taken along the line A-A' of FIG. 5.
FIG. 7 illustrates a cross-sectional view taken along the line B-B' of FIG. 5.
FIG. 8 illustrates an enlarged cross-sectional view of an area "A" of FIG. 6.
FIG. 9 - FIG. 13 illustrate cross-sectional views of process steps of a manufacturing method of a display device according to one or more embodiments.

### DETAILED DESCRIPTION

Aspects of embodiments of the present disclosure and methods of accomplishing the same may be understood more readily by reference to the following detailed description of embodiments of the present disclosure and the accompanying drawings. The present disclosure may, however, be embodied in different forms and should not be construed as limited to the embodiments set forth herein. The embodiments of the present disclosure are provided so that the present disclosure will be thorough and complete, and will fully convey the scope of the present invention which is defined by the appended claims.

The terms used herein are for the purpose of describing particular embodiments only and is not intended to be limiting. As used herein, the singular forms "a," "an" and "the" are intended to include the plural forms as well, unless the context clearly indicates otherwise. It will be further understood that the terms "comprise" and/or "comprising," "include" or "including," and "have" or "having," when used in the present disclosure, specify the presence of stated elements, steps, operations, and/or devices, but do not preclude the presence or addition of one or more other elements, steps, operations, and/or devices.

In addition, the term "connection (connecting)" or "coupling" may comprehensively mean a physical and/or electrical connection (connecting) or coupling. Further, this may comprehensively mean a direct or indirect connection (connecting) or coupling, and an integrated or non-integrated connection (connecting) or coupling.

It will be understood that when an element or a layer is referred to as being 'on' another element or layer, it can be directly on another element or layer, or one or more intervening elements or layers may also be present. Throughout the specification, the same reference numerals denote the same constituent elements.

Although the terms "first," "second," and the like are used to describe various constituent elements, these constituent elements are not limited by these terms. These terms are used only to distinguish one constituent element from another constituent element. Therefore, the first constituent elements described below may be the second constituent elements in embodiments of the present disclosure.

Hereinafter, embodiments of the present disclosure will be described in detail with reference to the accompanying drawings.

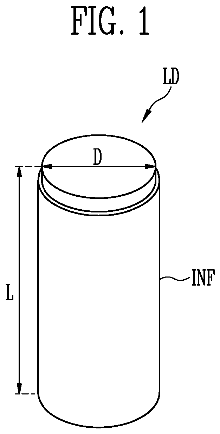

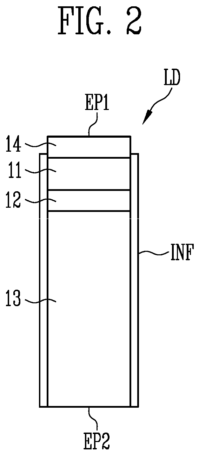

FIG. 1 and FIG. 2 illustrate a perspective view and a cross-sectional view of a light emitting element according to one or more embodiments, respectively. FIG. 1 and FIG. 2 illustrate a cylindrical shape light emitting element LD, but a type and/or shape of the light emitting element LD of embodiments is not limited thereto.

Referring to FIG. 1 and FIG. 2, a light emitting element LD may include a first semiconductor layer 11, an active layer 12, a second semiconductor layer 13, and/or an electrode layer 14.

The light emitting element LD may be formed to have a cylindrical shape extending along one direction. The light emitting element LD may have a first end portion EP1 and a second end portion EP2. One of the first and second semiconductor layers 11 and 13 may be located on the first end portion EP1 of the light emitting element LD. The remaining one of the first and second semiconductor layers 11 and 13 may be located on the second end portion EP2 of the light emitting element LD. For example, the first semiconductor layer 11 may be located on the first end portion EP1 of the light emitting element LD, and the second semiconductor layer 13 may be located on the second end EP2 of the light emitting element LD.

In one or more embodiments, the light emitting element LD may be a light emitting element manufactured in a cylindrical shape through an etching method or the like. In the present specification, the "cylindrical shape" includes a rod-like shape or bar-like shape with an aspect ratio greater than 1, such as a circular cylinder or a polygonal cylinder, but a shape of a cross-section thereof is not limited in embodiments.

The light emitting element LD may have a size as small as a nanometer scale to a micrometer scale. For example, the light emitting element LD may each have a diameter D (or width) and/or a length L ranging from a nanometer scale to a micrometer scale. However, the size of the light emitting element LD of embodiments is not limited thereto, and the size of the light emitting element LD may be variously changed according to design conditions of various devices using a light emitting device using the light emitting element LD as a light source, for example, a display device.

The first semiconductor layer 11 may be a first conductive semiconductor layer. For example, the first semiconductor layer 11 may include a p-type semiconductor layer. For example, the first semiconductor layer 11 may include at least one semiconductor material of InAlGaN, GaN, AlGaN, InGaN, AIN, and InN, and may include a p-type semiconductor layer doped with a first conductive dopant such as Mg. However, the material included in the first semiconductor layer 11 of embodiments is not limited thereto, and the first semiconductor layer 11 may be made of various materials.

The active layer 12 may be located between the first semiconductor layer 11 and the second semiconductor layer 13, and may be formed to have a single-quantum well structure or multi-quantum well structure. A position of the active layer 12 may be variously changed according to a type of the light emitting element LD. In one or more embodiments, a material such as AlGaN and InAlGaN may be used to form the active layer 12, and in addition, various materials may form the active layer 12. A clad layer doped with a conductive dopant may be formed at an upper portion and/or a lower portion of the active layer 12. For example, the cladding layer may be formed of AlGaN or InAlGaN.

The second semiconductor layer 13 is located on the active layer 12, and may include a semiconductor layer of a type that is different from that of the first semiconductor layer 11. The second semiconductor layer 13 may include an n-type semiconductor layer. For example, the second semiconductor layer 13 may include a semiconductor material of one of InAlGaN, GaN, AlGaN, InGaN, AIN, and InN, and may include an n-type semiconductor layer doped with a second conductive dopant such as Si, Ge, Sn, or the like. However, the material included in the second semiconductor layer 13 of embodiments is not limited thereto, and the second semiconductor layer 13 may be made of various materials.

When a voltage of a threshold voltage or more is applied to respective ends (e.g., the first end portion EP1 and the second end portion EP2) of the light emitting element LD, the light emitting element LD emits light while electron-hole pairs are combined in the active layer 12. By controlling the light emission of the light emitting element LD by using this principle, the light emitting element LD may be used as a light source for various light emitting devices in addition to pixels of a display device.

The electrode layer 14 may be located on the first end portion EP1 and/or the second end portion EP2 of the light emitting element LD. FIG. 2 illustrates a case in which the electrode layer 14 is formed on the first semiconductor layer 11, but embodiments the present disclosure are not necessarily limited thereto. For example, a separate electrode layer may be further located on the second semiconductor layer 13 at the second end portion EP2.

The electrode layer 14 may include a transparent metal or transparent metal oxide. As an example, the electrode layer 14 may include at least one of an indium tin oxide (ITO), an indium zinc oxide (IZO), a zinc oxide (ZnO), and a zinc tin oxide (ZTO), but embodiments are not limited thereto. As such, when the electrode layer 14 is made of the transparent metal or transparent metal oxide, light generated in the active layer 12 of the light emitting element LD may transmit through the electrode layer 14 to be emitted to the outside of the light emitting element LD..

The light emitting element LD may further include an insulating film INF formed on a surface (e.g., an outer circumferential surface) thereof. The insulating film INF may be directly located on surfaces (e.g., outer circumferential surfaces) of the first semiconductor layer 11, the active layer 12, the second semiconductor layer 13, and/or the electrode layer 14. The insulating film INF may expose the first and second end portions EP1 and EP2 of the light emitting element LD having different polarities. In one or more embodiments, the insulating film INF may expose side portions of the electrode layer 14 and/or the second semiconductor layer 13 that are adjacent to the first and second end portions EP1 and EP2 of the light emitting element LD.

The insulating film INF may include at least one of an aluminum oxide (AlOx), an aluminum nitride (AlNx), a silicon oxide (SiOx), a silicon nitride (SiNx), a silicon oxynitride (SiOxNy), a zirconium oxide (ZrOx), a hafnium oxide (HfOx), and a titanium oxide (TiOx). For example, the insulating film INF may be configured as a double layer, and respective layers configuring the double layer may include different materials. In this case, respective layers configuring the double layer of the insulating film INF may be formed by different processes. In one or more embodiments, the insulating film INF may be configured as a double layer made of an aluminum oxide (AlOx) and a silicon oxide (SiOx), but embodiments are not limited thereto. In one or more embodiments, the insulating film INF may be omitted.

When the insulating film INF is provided on the surface (e.g., the outer circumferential surface) of the light emitting element LD, it is possible to reduce or prevent the likelihood of the active layer 12 being short-circuited with at least one electrode (for example, at least one of electrodes connected to respective ends of the light emitting element LD). Therefore, electrical stability of the light emitting element LD may be secured. Further, it is possible to improve the life-span and efficiency of the light emitting element LD by reducing or minimizing surface-defects of the light emitting element LD.

A light emitting device including the light emitting element LD described above may be used in various types of devices that require a light source in addition to a display device. For example, the light emitting elements LD may be located in each pixel of a display panel, and the light emitting elements LD may be used as a light source of each pixel. However, an application field of the light emitting element LD of embodiments is not limited to the above-described example. For example, the light emitting element LD may be used in other types of devices that require a light source, such as a lighting device.

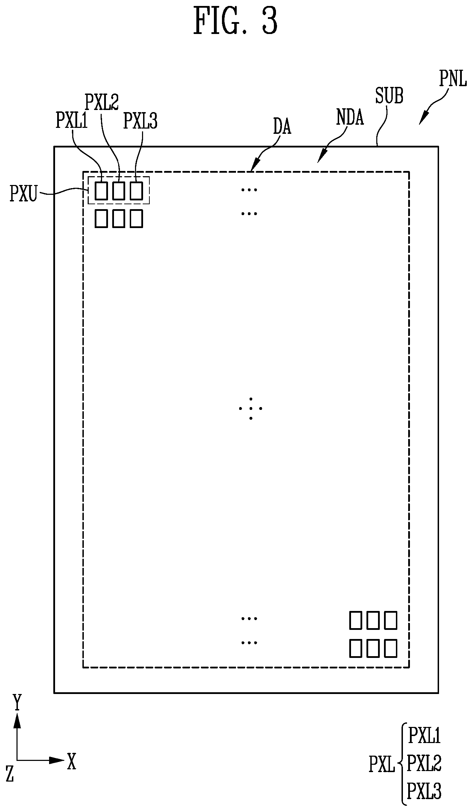

FIG. 3 illustrates a top plan view of a display device according to one or more embodiments.

FIG. 3 illustrates a display device, for example, a display panel PNL provided in the display device as an example of an electronic device that may use the light emitting element LD described in the embodiments of FIG. 1 and FIG. 2 as a light source.

Each pixel unit PXU of the display panel PNL and each pixel configuring the same may include at least one light emitting element LD. For better understanding and ease of description, FIG. 3 briefly illustrates the structure of the display panel PNL based on a display area DA. However, in one or more embodiments, at least one driving circuit portion (for example, at least one of a scan driver and a data driver), wires, and/or pads, may be further located in the display panel PNL.

Referring to FIG. 3, the display panel PNL may include a substrate SUB and the pixel unit PXU located on the substrate SUB. The pixel unit PXU may include first pixels PXL1, second pixels PXL2, and/or third pixels PXL3. Hereinafter, when arbitrarily referring to one or more pixels among the first pixels PXL1, the second pixels PXL2, and the third pixels PXL3, or when comprehensively referring to two or more types of pixels, they will be referred to as a "pixel PXL" or "pixels PXL."

The substrate SUB configures a base member of the display panel PNL, and may be a rigid or flexible substrate or film. For example, the substrate SUB may be formed as a rigid substrate made of glass or tempered glass and as a flexible substrate made of a plastic or metallic material (or a thin film), but the material and/or physical properties of the substrate SUB of embodiments are not particularly limited.

The display panel PNL and the substrate SUB for forming the display panel include a display area DA for displaying an image and a non-display area NDA excluding the display area DA. in some embodiments, the non-display area NDA may be around the edge or periphery of the display area DA. The pixels PXL may be located in the display area DA. In the non-display area NDA, various wires connected to the pixels PXL of the display area DA, pads, and/or internal circuit parts may be located. The pixels PXL may be regularly arranged according to a stripe or PENTILE^{™} arrangement structure, but embodiments the present disclosure are not limited thereto. This PENTILE^{®} arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea. However, the arrangement structure of the pixels PXL of embodiments is not limited thereto, and the pixels PXL may be arranged in the display area DA in various structures and/or methods.

In one or more embodiments, two or more types of pixels PXL emitting light of different colors may be located in the display area DA. For example, in the display area DA, the first pixels PXL1 emitting light of the first color, the second pixels PXL2 emitting light of the second color, and the third pixels PXL3 emitting light of the third color may be arranged. At least one of the first to third pixels PXL1, PXL2, and PXL3 that are adjacent to each other may form one pixel unit PXU that may emit light of various colors. For example, each of the first to third pixels PXL1, PXL2, and PXL3 may be a sub-pixel that emits light of a desired color (e.g., a set or predetermined color). According to one or more embodiments, the first pixel PXL1 may be a red pixel that emits red light, the second pixel PXL2 may be a green pixel that emits green light, and the third pixel PXL3 may be a blue pixel that emits blue light, but embodiments the present disclosure are not limited thereto.

In one or more embodiments, the first pixel PXL1, the second pixel PXL2, and the third pixel PXL3 are provided with light emitting elements of the same color, and include color conversion layers and/or color filters of different colors located on respective light emitting elements, so that they may emit light of the first color, the second color, and the third color, respectively. In one or more embodiments, the first pixel PXL1, the second pixel PXL2, and the third pixel PXL3 are each provided with a first color light emitting element, a second color light emitting element, and a third color light emitting element as a light source, respectively, so that they respectively emit light of the first color, the second color, and the third color. However, the color, type, and/or number of pixels PXL configuring each pixel unit PXU of embodiments are not particularly limited. That is, the color of light emitted by each pixel PXL may be variously changed.

The pixel PXL may include at least one light source driven by a suitable control signal (e.g. a set or predetermined control signal) (for example, a scan signal and a data signal) and/or a power source (e.g., a set or predetermined power source) (for example, a first power source and a second power source). In one or more embodiments, the light source may include at least one light emitting element LD according to one of the embodiments of FIG. 1 and FIG. 2, for example, ultra-small cylindrical shape light emitting elements LD having a size as small as nanometer scale to micrometer scale. However, embodiments of the present disclosure are not limited thereto, and various types of light emitting elements LD may be used as a light source of the pixel PXL.

In one or more embodiments, each pixel PXL may be configured as an active pixel. However, the type, structure, and/or driving method of pixels PXL that may be applied to the display device of embodiments are not particularly limited. For example, each pixel PXL may be configured as a pixel of a passive or active light emitting display device of various structures and/or driving methods.

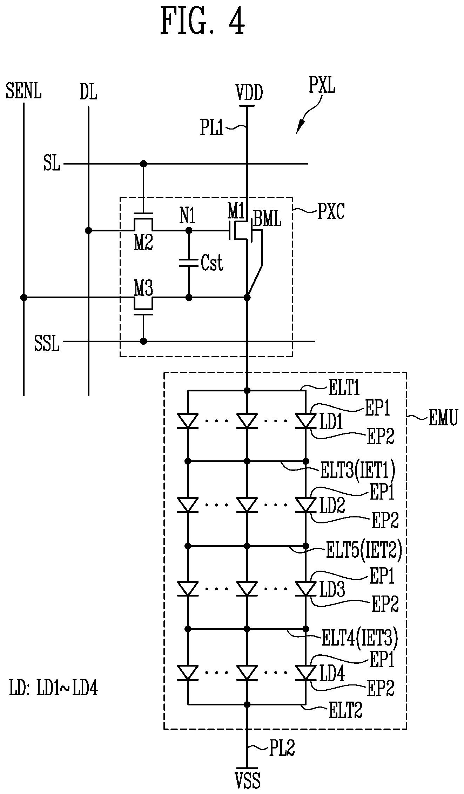

FIG. 4 illustrates a circuit diagram of a pixel according to one or more embodiments.

In one or more embodiments, the pixel PXL shown in FIG. 4 may be one of the first pixel PXL1, the second pixel PXL2, and the third pixel PXL3 provided in the display panel PNL of FIG. 3. The first pixel PXL1, the second pixel PXL2, and the third pixel PXL3 may have substantially the same or similar structure.

Referring to FIG. 4, the pixel PXL may further include a light emitting part EMU for generating light at luminance corresponding to a data signal, and a pixel circuit PXC for driving a light emitting part EMU.

The pixel circuit PXC may be connected between a first power source VDD and the light emitting part EMU. In addition, the pixel circuit PXC may be connected to a scan line SL and a data line DL of the pixel PXL to control an operation of the light emitting part EMU in response to a scan signal and a data signal supplied from the scan line SL and the data line DL. The pixel circuit PXC may be further selectively connected to a sensing signal line SSL and a sensing line SENL.

The pixel circuit PXC may include at least one transistor and a capacitor. For example, the pixel circuit PXC may include a first transistor M1, a second transistor M2, a third transistor M3, and a storage capacitor Cst.

The first transistor M1 may be connected between the first power source VDD and a first connecting electrode ELT1. A gate electrode of the first transistor M1 may be connected to a first node N1. The first transistor M1 may control a driving current supplied to the light emitting part EMU in response to a voltage of the first node N1. That is, the first transistor M1 may be a driving transistor that controls a driving current of the pixel PXL.

In one or more embodiments, the first transistor M1 may optionally include a bottom metal layer BML (also referred to as a "lower electrode," "back gate electrode," or "lower light blocking layer"). The gate electrode of the first transistor M1 and the bottom metal layer BML may overlap each other with an insulating layer interposed therebetween. In one or more embodiments, the bottom metal layer BML may be connected to one electrode of the first transistor M1, for example, a source electrode or a drain electrode thereof.

When the first transistor M1 includes the bottom metal layer BML, by applying a back-biasing voltage to the bottom metal layer BML of the first transistor M1 when the pixel PXL is driven, a back-biasing technique (or a sync technique) of moving a threshold voltage of the first transistor M1 in a negative or positive direction may be applied. For example, by connecting the bottom metal layer BML to the source electrode of the first transistor M1 to apply a source-sync technique, the threshold voltage of the first transistor M1 may be moved in the negative or positive direction. In addition, when the bottom metal layer BML is located under a semiconductor pattern forming a channel of the first transistor M1, the bottom metal layer BML may serve as a light blocking pattern to stabilize an operating characteristic of the first transistor M1. However, the function and/or utilization method of the bottom metal layer BML of embodiments is not limited thereto.

The second transistor M2 may be connected between the data line DL and the first node N1. A gate electrode of the second transistor M2 may be connected to a scan line SL. When a scan signal of a gate-on voltage (for example, a high level voltage) is supplied from the scan line SL, the second transistor M2 may be turned on to connect the data line DL and the first node N1.

For each frame period, a data signal of the corresponding frame is supplied to the data line DL, and the data signal be transmitted to the first node N1 through the turned-on second transistor M2 during a period in which the scan signal of the gate-on voltage is supplied. That is, the second transistor M2 may be a switching transistor for transmitting each data signal to the inside of the pixel PXL.

One electrode of the storage capacitor Cst may be connected to the first node N1, and the other electrode thereof may be connected to a second electrode (e.g., the source electrode) of the first transistor M1. The storage capacitor Cst may be charged with a voltage (or may hold a charge) corresponding to the data signal supplied to the first node N1 during each frame period.

The third transistor M3 may be connected between the first connecting electrode ELT1 (or the second electrode of the first transistor M1) and the sensing line SENL. A gate electrode of the third transistor M3 may be connected to the sensing signal line SSL. The third transistor M3 may transmit a voltage applied to the first connecting electrode ELT1 to the sensing line SENL according to a sensing signal supplied to the sensing signal line SSL. The voltage transmitted through the sensing line SENL may be provided to an external circuit (for example, a timing controller), and the external circuit may detect characteristic information (for example, a threshold voltage of the first transistor M1) of each pixel PXL based on the supplied voltage. The detected characteristic information may be used to convert image data so that a characteristic deviation between the pixels PXL is compensated.

Although in FIG. 4, all the transistors included in the pixel circuit PXC are illustrated as N-type transistors, embodiments of the present disclosure are not limited thereto. For example, at least one of the first, second, and third transistors M1, M2, and M3 may be changed to a P-type transistor.

In addition, the structure and driving method of the pixel PXL may be variously changed. For example, the pixel circuit PXC may be configured as a pixel circuit having various structures and/or driving methods in addition to that of the embodiments corresponding to FIG. 4.

For example, the pixel circuit PXC may not include the third transistor M3. In addition, the pixel circuit PXC may further include other circuit elements such as a compensation transistor for compensating for a threshold voltage of the first transistor M1, an initialization transistor for initializing the voltage of the first node N1 and/or of the first connecting electrode ELT1, a light emission control transistor for controlling a period in which a driving current is supplied to the light emitting part EMU, and/or a boosting capacitor for boosting the voltage of the first node N1.

The light emitting part EMU may include at least one light emitting element LD connected between the first power source VDD and a second power source VSS, for example, a plurality of light emitting elements LD connected between the first power source VDD and a second power source VSS.

For example, the light emitting part EMU may include the first connecting electrode ELT1 connected to the first power source VDD through the pixel circuit PXC and a first power line PL1, a second connecting electrode ELT2 connected to the second power source VSS through a second power line PL2, and a plurality of light emitting elements LD connected between the first and second connecting electrodes ELT1 and ELT2.

The first and second power sources VDD and VSS may have different potentials so that the light emitting elements LD may emit light. For example, the first power source VDD may be set as a high potential power source, and the second power source VSS may be set as a low potential power source.

In one or more embodiments, the light emitting part EMU may include at least one serial stage. Each serial stage may include a pair of electrodes (for example, two electrodes) and at least one light emitting element LD connected in a forward direction between the pair of electrodes. Here, the number of serial stages forming the light emitting part EMU and the number of light emitting elements LD forming each serial stage of embodiments are not particularly limited. For example, the number of the light emitting elements LD configuring respective serial stages may be the same as or different from each other, but the number of the light emitting elements LD of embodiments is not particularly limited.

For example, the light emitting part EMU may include a first serial stage including at least one first light emitting element LD1, a second serial stage including at least one second light emitting element LD2, a third serial stage including at least one third light emitting element LD3, and a fourth serial stage including at least one fourth light emitting element LD4.

The first serial stage may include the first connecting electrode ELT1, the third connecting electrode ELT3, and at least one first light emitting element LD1 connected between the first and third connecting electrodes ELT1 and ELT3. Each first light emitting element LD1 may be connected in a forward direction between the first and third connecting electrodes ELT1 and ELT3. For example, the first end portion EP1 of the first light emitting element LD1 may be connected to the first connecting electrode ELT1, and the second end portion EP2 of the first light emitting element LD1 may be connected to the third connecting electrode ELT3.

The second serial stage may include the third connecting electrode ELT3, the fifth connecting electrode ELT5, and at least one second light emitting element LD2 connected between the third and fifth connecting electrodes ELT3 and ELT5. Each second light emitting element LD2 may be connected in a forward direction between the third and fifth connecting electrodes ELT3 and ELT5. For example, the first end portion EP1 of the second light emitting element LD2 may be connected to the third connecting electrode ELT3, and the second end portion EP2 of the second light emitting element LD2 may be connected to fifth connecting electrode ELT5.

The third serial stage may include the fifth connecting electrode ELT5, the fourth connecting electrode ELT4, and at least one third light emitting element LD3 connected between the fourth and fifth connecting electrodes ELT4 and ELT5. Each third light emitting element LD3 may be connected in a forward direction between the fifth and fourth connecting electrodes ELT5 and ELT4. For example, the first end portion EP1 of the third light emitting element LD3 may be connected to the fifth connecting electrode ELT5, and the second end portion EP2 of the third light emitting element LD3 may be connected to fourth connecting electrode ELT4.

The fourth serial stage may include the fourth connecting electrode ELT4, the second connecting electrode ELT2, and at least one fourth light emitting element LD4 connected between the second and fourth connecting electrodes ELT2 and ELT4. Each fourth light emitting element LD4 may be connected in a forward direction between the fourth and second connecting electrodes ELT4 and ELT2. For example, the first end portion EP1 of the fourth light emitting element LD4 may be connected to the fourth connecting electrode ELT4, and the second end portion EP2 of the fourth light emitting element LD4 may be connected to the second connecting electrode ELT2.

A first electrode of the light emitting part EMU, for example, the first connecting electrode ELT1 may be an anode electrode of the light emitting part EMU. A last electrode of the light emitting part EMU, for example, the second connecting electrode ELT2 may be a cathode electrode of the light emitting part EMU.

The remaining electrodes of the light emitting part EMU, for example, the third connecting electrode ELT3, the fourth connecting electrode ELT4, and/or the fifth connecting electrode ELT5, may be configured as intermediate electrodes. For example, the third connecting electrode ELT3 may be configured as the first intermediate electrode IET1, the fifth connecting electrode ELT5 may be configured as the second intermediate electrode IET2, and the fourth connecting electrode ELT4 may be configured the third intermediate electrode IET3.

When the light emitting elements LD are connected in a serial and/or parallel structure, power efficiency may be improved compared with when the same number of light emitting elements LD are connected only in parallel. In addition, in the pixel PXL in which the light emitting elements LD are connected in a serial and/or parallel structure, even if a short circuit defect occurs at some of the serial stages, because a desired luminance (e.g., a set or predetermined luminance) may be displayed through the light emitting elements LD in the remaining serial stages, the possibility of dark spot defects of the pixel PXL may be reduced. However, the present disclosure is not limited thereto, and the light emitting part EMU may be configured by connecting the light emitting elements LD only in series or only in parallel.

Each of the light emitting elements LD may include at least one electrode (for example, the first connecting electrode ELT1), the first end portion EP1 (for example, a p-type end portion) connected to the first power source VDD via the pixel circuit PXC and/or the first power line PL1, and the second end portion EP2 (for example, an n-type end portion) connected to the second power source VSS via at least one other electrode (for example, the second connecting electrode ELT2) and the second power line PL2. That is, the light emitting elements LD may be connected in a forward direction between the first power source VDD and the second power source VSS. The light emitting elements LD connected in the forward direction may configure the effective light sources of the light emitting part EMU.

When a driving current is supplied through the corresponding pixel circuit PXC, the light emitting elements LD may emit light with luminance corresponding to the driving current . For example, during each frame period, the pixel circuit PXC may supply a driving current corresponding to a gray value to be displayed in the corresponding frame to the light emitting part EMU. Accordingly, while the light emitting elements LD emit light with luminance corresponding to the driving current, the light emitting part EMU may display the luminance corresponding to the driving current.

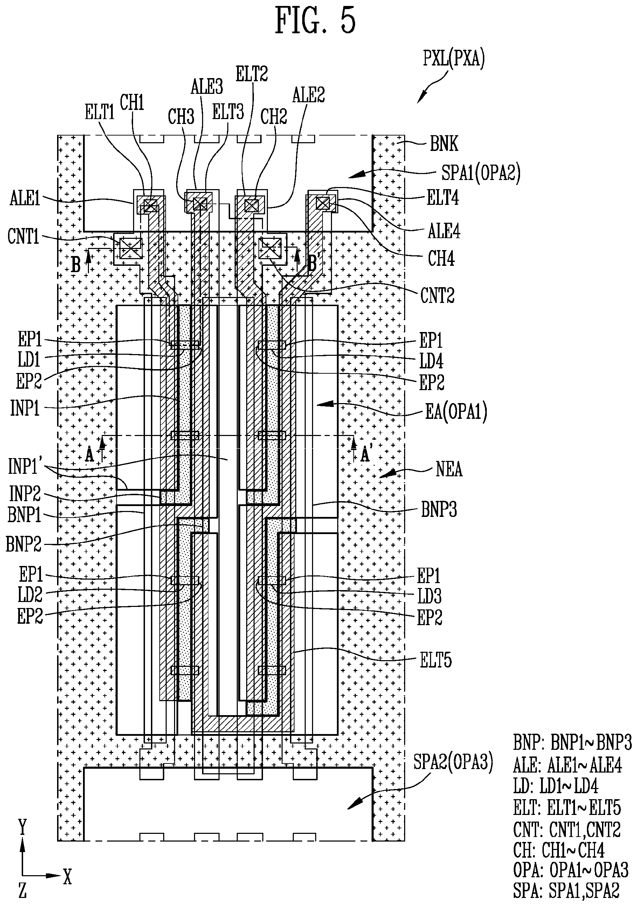

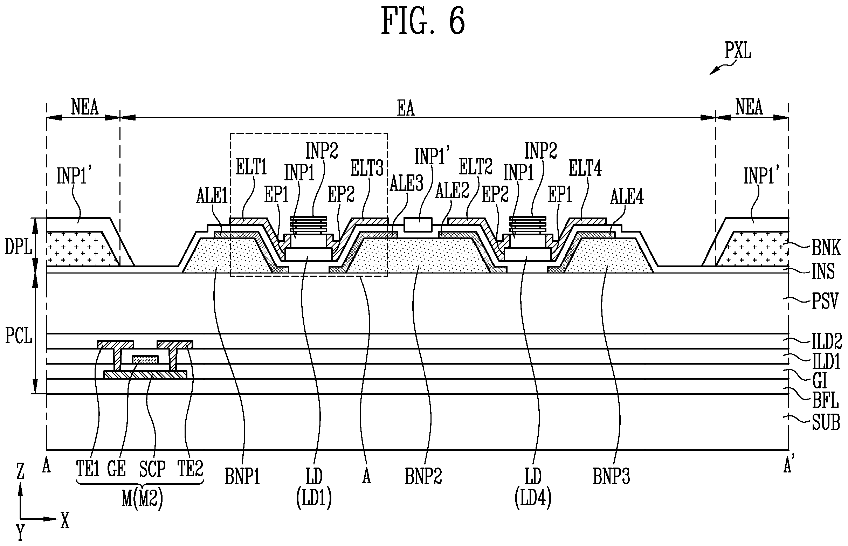

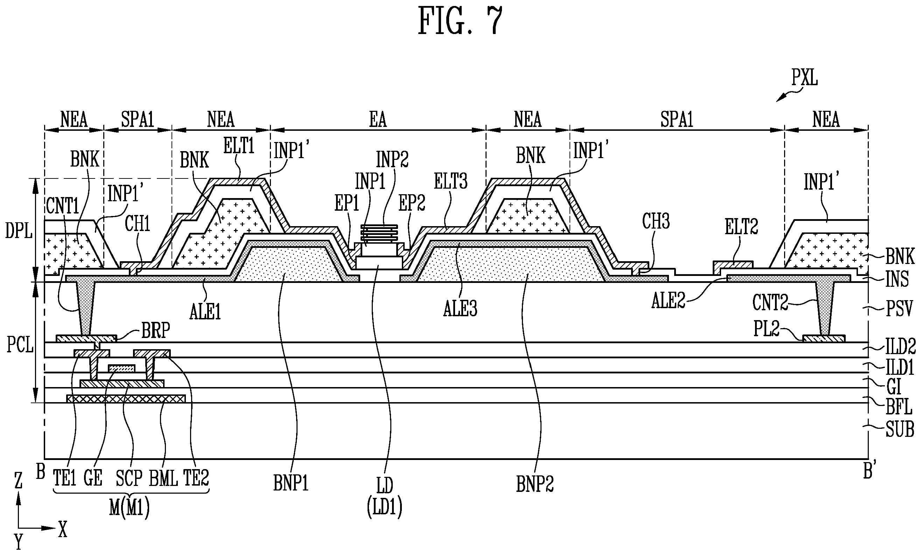

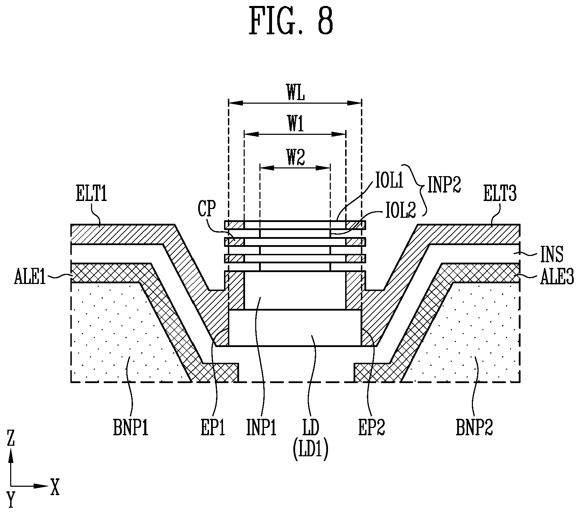

FIG. 5 illustrates a top plan view of a pixel according to one or more embodiments. FIG. 6 illustrates a cross-sectional view taken along the line A-A' of FIG. 5. FIG. 7 illustrates a cross-sectional view taken along the line B-B' of FIG. 5. FIG. 8 illustrates an enlarged cross-sectional view of an area "A" of FIG. 6.

As an example, FIG. 5 may be one of the first to third pixels PXL1, PXL2, and PXL3 configuring the pixel unit PXU of FIG. 3, and the first to third pixels PXL1, PXL2, and PXL3 may be substantially the same or similar to each other. In addition, FIG. 5 illustrates one or more embodiments in which each pixel PXL includes the light emitting elements LD located in the four serial stages as shown in FIG. 4, but the number of serial stages of each pixel PXL may be variously changed according to embodiments.

Hereinafter, when arbitrarily referring to one or more light emitting element among first to fourth light emitting elements LD1 to LD4, or comprehensively referring to two or more light emitting elements, it or they will be referred to as a "light emitting element LD" or "light emitting elements LD" will be referred. In addition, when arbitrarily referring to at least one of electrodes including first to fourth electrodes ALE1, ALE2, ALE3, and ALE4, it or they will be referred to as an "electrode ALE" or "electrodes ALE," and when arbitrarily referring to at least one of electrodes including first to fifth connecting electrodes ELT1 to ELT5, it or they will be referred to as an "connecting electrode ELT" or "connecting electrodes ELT."

Referring to FIG. 5, each pixel PXL may include a light emitting area EA, a non-light emitting area NEA, and a separating area SPA. The light emitting area EA may be an area that may emit light by including the light emitting elements LD. The non-light emitting area NEA may be located to be around (e.g., surround) the light emitting area EA. The non-light emitting area NEA may be an area in which a bank BNK that is around (e.g., surrounding) the light emitting area EA is provided. The separating area SPA may be spaced from the light emitting area EA with the non-light emitting area NEA interposed therebetween. The separating area SPA may include a first separating area SPA1 located at one side of the light emitting area EA, and a second separating area SPA2 located at the other side of the light emitting area EA. The separating area SPA may be an area of the remaining pixel areas PXA excluding the light emitting area EA, which is located in an opening OPA of the bank BNK and in which at least one electrode ALE is separated or cut (disconnected).

Each pixel PXL may include patterns BNP, electrodes ALE, light emitting elements LD, first insulating pattern INP1, second insulating pattern INP2, and connecting electrodes ELT.

The patterns BNP may be provided in at least light emitting area EA. The patterns BNP may extend along a second direction (Y-axis direction), and may be spaced from each other along a first direction (X-axis direction).

The patterns BNP (also referred to as "wall patterns" or "bank patterns") may partially overlap at least one electrode (ALE) in a thickness direction of the substrate SUB (Z-axis direction) in at least light emitting area EA. For example, the first pattern BNP1 may be provided under the first electrode ALE1 so as to overlap one area of the first electrode ALE1 in the Z-axis direction, the second pattern BNP2 may be provided under the second and third electrodes ALE2 and ALE3 so as to overlap one area of each of the second and third electrodes ALE2 and ALE3 in the Z-axis direction, and the third pattern BNP3 may be provided under the fourth electrode ALE4 so as to overlap one area of the fourth electrode ALE4 in the Z-axis direction.

As the patterns BNP are provided under one area of each of the electrodes ALE, one area of each of the electrodes ALE in areas in which the patterns BNP are formed may protrude in an upward direction of the pixel PXL, that is, a third direction( e.g., the Z-axis direction). When the patterns BNP and/or electrodes ALE include a reflective material, a reflective wall structure may be formed around the light emitting elements LD. Accordingly, as light emitted from the light emitting elements LD may be directed in an upward direction (for example, a front direction of the display panel PNL including a suitable viewing angle range (e.g., a set or predetermined viewing angle range) of the pixel PXL, light emission efficiency of the pixel PXL may be improved.

The electrodes ALE may be provided in at least light emitting area EA. The electrodes ALE extend along a second direction (Y-axis direction), and are spaced from each other in a first direction (X-axis direction). The electrodes ALE may extend from the light emitting area EA through the non-light emitting area NEA to the separating area SPA, and may be separated or cut off in the separating area SPA. For example, each of the first to fourth electrodes ALE1 to ALE4 extends from the light emitting area EA to the first and second separating areas SPA1 and SPA2, and is cut off in the first and second separating areas SPA1 and SPA2, so that it may be separated from the electrodes ALE of an adjacent pixel PXL (e.g., a pixel PXL adjacent in the Y-axis direction). However, embodiments of the present disclosure are not limited thereto, and at least one of the electrodes ALE may not be cut off in the separating area SPA, and may be integrally connected with one of the electrodes ALE of the adjacent pixel PXL (e.g., a pixel PXL adjacent in the Y-axis direction).

In one or more embodiments, some of the electrodes ALE may be connected to the pixel circuit PXC and/or a suitable power line (e.g., a set or predetermined power line) through a contact part CNT. For example, the first electrode ALE1 may be connected to the pixel circuit PXC and/or the first power line PL1 through a first contact part CNT1, and the second electrode ALE2 may be connected to the second power line PL2 through a second contact part CNT2. The contact part CNT may be provided in the non-light emitting area NEA, but embodiments are not limited thereto.

In one or more embodiments, at least one of the electrodes ALE may be connected to at least one of the connecting electrodes ELT through a contact hole CH. For example, the first electrode ALE1 may be electrically connected to the first connecting electrode ELT1 through a first contact hole CH1, and the second electrode ALE2 may be electrically connected to the second connecting electrode ELT2 through a second contact hole CH2. In addition, the third electrode ALE3 may be electrically connected to the third connecting electrode ELT3 through a third contact hole CH3, and the fourth electrode ALE4 may be electrically connected to the fourth connecting electrode ELT4 through a fourth contact hole CH4. The contact holes CH may be provided in the separating area SPA, but embodiments are not limited thereto.

Each of the electrodes ALE may be located on at least one pattern BNP. For example, the first electrode ALE1 may be located in one area of the first pattern BNP1, the second and third electrodes ALE2 and ALE3 may be located in different areas of the second pattern BNP2, and the fourth electrode ALE4 may be located in one area of the third pattern BNP3. In one or more embodiments, when the third electrode ALE3 is located between the first and second electrodes ALE1 and ALE2, the third electrode ALE3 may be located at one (or left) area of the second pattern BNP2, and the second electrode ALE2 may be located at the other (or right) area of the second pattern BNP2.

A pair of electrodes ALE adjacent to each other may receive different signals in an alignment step of the light emitting elements LD. For example, when the first electrode ALE1, the third electrode ALE3, the second electrode ALE2, and the fourth electrode ALE4 are sequentially arranged along the first direction (X-axis direction) in the light emitting area EA, the first and third electrodes ALE1 and ALE3 may form a pair to receive different alignment signals, and the second and fourth electrodes ALE2 and ALE4 may form a pair to receive different alignment signals.

In one or more embodiments, the second and third electrodes ALE2 and ALE3 may receive the same signal in the alignment step of the light emitting elements LD. The second and third electrodes ALE2 and ALE3 may be integrally or non-integrally connected to each other in the alignment step of the light emitting elements LD, but embodiments are not limited thereto.

Each of the light emitting elements LD may be aligned between a pair of patterns BNP in the light emitting area EA. Each of the light emitting elements LD **is** electrically connected between a pair of connecting electrodes ELT, and may have provide an anastomosis connection between the pair of connecting electrodes ELT.

The first light emitting element LD1 may be aligned between the first and second patterns BNP1 and BNP2. The first light emitting element LD1 may be anastomosis electrically connected between the first and third connecting electrodes ELT1 and ELT3. As an example, the first light emitting element LD1 may be aligned at one side (or an upper end) of an area between the first and second patterns BNP1 and BNP2, and the first end portion EP1 of the first light emitting element LD1 may electrically connected to the first connecting electrode ELT1, and the second end portion EP2 of the first light emitting element LD1 may be electrically connected to the third connecting electrode ELT3.

The second light emitting element LD2 may be aligned between the first and second patterns BNP1 and BNP2. The second light emitting element LD2 may be electrically connected between the third and fifth connecting electrodes ELT3 and ELT5. As an example, the second light emitting element LD2 may be aligned at the other side (or a lower end) of an area between the first and second patterns BNP1 and BNP2, and the first end portion EP1 of the second light emitting element LD2 may electrically connected to the third connecting electrode ELT3, and the second end portion EP2 of the second light emitting element LD2 may be electrically connected to the fifth connecting electrode ELT5.

The third light emitting element LD3 may be aligned between the second and third patterns BNP2 and BNP3. The third light emitting element LD3 may be electrically connected between the fourth and fifth connecting electrodes ELT4 and ELT5. As an example, the third light emitting element LD3 may be aligned at the other side (or a lower end) of an area between the second and third patterns BNP2 and BNP3, and the first end portion EP1 of the third light emitting element LD3 may electrically connected to the fifth connecting electrode ELT5, and the second end portion EP2 of the third light emitting element LD3 may be electrically connected to the fourth connecting electrode ELT4.

The fourth light emitting element LD4 may be aligned between the second and third patterns BNP2 and BNP3. The fourth light emitting element LD4 may be electrically connected between the second and fourth connecting electrodes ELT2 and ELT4. As an example, the fourth light emitting element LD4 may be aligned at one side (or an upper end) of an area between the second and third patterns BNP2 and BNP3, and the first end portion EP1 of the fourth light emitting element LD4 may electrically connected to the fourth connecting electrode ELT4, and the second end portion EP2 of the fourth light emitting element LD4 may be electrically connected to the second connecting electrode ELT2.

For example, the first light emitting element LD1 may be located in an upper left area of the light emitting area EA, and the second light emitting element LD2 may be located in a lower left area of the light emitting area EA. The third light emitting element LD3 may be located in a lower right area of the light emitting area EA, and the fourth light emitting element LD4 may be located in an upper right area of the light emitting area EA. However, the arrangement and/or connection structure of the light emitting elements LD may be variously changed depending on the structure of the light emitting part EMU and/or the number of serial stages.

The first insulating pattern INP1 is located to overlap the light emitting elements LD in the light emitting area EA. For example, the first insulating pattern INP1 is located to overlap the first light emitting elements LD1 between the first and third connecting electrodes ELT1 and ELT3. In addition, the first insulating pattern INP1 may be located to overlap the second light emitting elements LD2 between the third and fifth connecting electrodes ELT3 and ELT5. Further, the first insulating pattern INP1 may be located to overlap the third light emitting elements LD3 between the fourth and fifth connecting electrodes ELT4 and ELT5. Also, the first insulating pattern INP1 may be located to overlap the fourth light emitting elements LD4 between the second and fourth connecting electrodes ELT2 and ELT4. The first insulating pattern INP1 may extend along the second direction (Y-axis direction) between the connecting electrodes ELT, but embodiments are not limited thereto.

In one or more embodiments, the pixel PXL may include an extension INP1' extending from the first insulating pattern INP1. The extension INP1' may be connected to the first insulating pattern INP1 to serve to reduce or prevent the first insulating pattern INP1 from being peeled off. The extension INP1' may extend along the first direction (X-axis direction) from the first insulating pattern INP1. In one or more embodiments, the extension INP1' may additionally extend in the second direction (Y-axis direction) from the first insulating pattern INP1. The extension INP1' may extend to the non-light emitting area NEA to overlap the bank BNK. In addition, the extension INP1' may extend to the connecting electrodes ELT where the light emitting elements LD are not located to extend between the second and third connecting electrodes ELT2 and ELT3 and between the fourth and fifth connecting electrodes ELT4 and ELT5 along the second direction (Y-axis direction), but embodiments are not limited thereto.

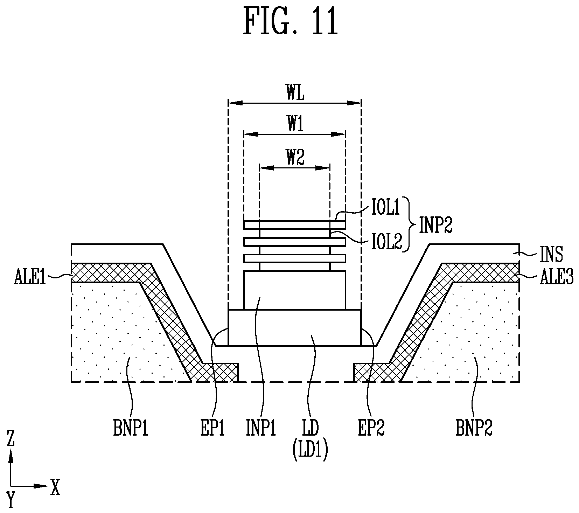

The second insulating pattern INP2 is located to overlap the light emitting elements LD and the first insulating pattern INP1 in the light emitting area EA. For example, the second insulating pattern INP2 is located to overlap the first light emitting elements LD1 and the first insulating pattern INP1 between the first and third connecting electrodes ELT1 and ELT3. In addition, the second insulating pattern INP2 may be located to overlap the second light emitting elements LD2 and/or the first insulating pattern INP1 between the third and fifth connecting electrodes ELT3 and ELT5. Further, the second insulating pattern INP2 may be located to overlap the third light emitting elements LD3 and/or the first insulating pattern INP1 between the fourth and fifth connecting electrodes ELT4 and ELT5. Also, the second insulating pattern INP2 may be located to overlap the fourth light emitting elements LD4 and/or the first insulating pattern INP1 between the second and fourth connecting electrodes ELT2 and ELT4. The second insulating pattern INP2 may extend along the second direction (Y-axis direction) between the connecting electrodes ELT, but embodiments are not limited thereto. The second insulating pattern INP2 serves to separate (or insulate from each other) the connecting electrodes ELT formed at respective ends of the light emitting elements LD. In this case, because the likelihood of a short circuit between the connecting electrodes ELT may be reduced or prevented by the second insulating pattern INP2, the connecting electrodes ELT may be concurrently formed (e.g., substantially simultaneously formed). That is, it is possible to simplify a manufacturing process of a display device by reducing the number of masks. A detailed description of this will be described later with reference to FIG. 11 - FIG. 13.

Each of the connecting electrodes ELT may be at least provided in the light emitting area EA, and may be located to overlap at least one electrode ALE and/or at least one light emitting element LD in the Z-axis direction. For example, each of the electrodes ELT may be formed on the electrodes ALE and/or the light emitting elements LD so as to overlap the electrodes ALE and/or the light emitting elements LD to be electrically connected to the light emitting elements LD.

The first connecting electrode ELT1 may be located on the first area (for example, the upper area) of the first electrode ALE1 and the first end portions EP1 of the first light emitting elements LD1 to be electrically connected to the first end portions EP1 of the first light emitting elements LD1.

The second connecting electrode ELT2 may be located on the first area (for example, the upper area) of the second electrode ALE2 and the second end portions EP2 of the fourth light emitting elements LD4 to be electrically connected to the second end portions EP2 of the fourth light emitting elements LD4. In addition, the second connecting electrode ELT2 may be electrically connected to the first, second, and third light emitting elements LD1, LD2, and LD3 via at least one other electrode ELT and/or light emitting element LD. For example, the second connecting electrode ELT2 may be electrically connected to the second end portions EP2 of the first light emitting elements LD1 via the third connecting electrode ELT3, the second light emitting element LD2, the fifth connecting electrode ELT5, the third light emitting element LD3, the fourth connecting electrode ELT4, and the fourth light emitting element LD4.

The third connecting electrode ELT3 may be located on the first area (for example, the upper area) of the third electrode ALE3 and the second end portions EP2 of the first light emitting elements LD1 to be electrically connected to the second end portions EP2 of the first light emitting elements LD1. In addition, the third connecting electrode ELT3 may be located on the second area (for example, the lower area) of the first electrode ALE1 and may be electrically connected to the first end portions EP1 of the second light emitting elements LD2. For example, the third connecting electrode ELT3 may connect the second end portions EP2 of the first light emitting elements LD1 and the first end portions EP1 of the second light emitting elements LD2 in the light emitting area EA. For this, the third connecting electrode ELT3 may have a curved shape. For example, the third connecting electrode ELT3 may have a curved or bent structure at a boundary between an area in which at least one first light emitting element LD1 is arranged and an area in which at least one second light emitting element LD2 is arranged.

In addition, the third connecting electrode ELT3 may be located between the first and second connecting electrodes ELT1 and ELT2, and may be electrically connected between the first and second connecting electrodes ELT1 and ELT2 through the light emitting elements LD. For example, the third connecting electrode ELT3 is connected to the first connecting electrode ELT1 through at least one first light emitting element LD1, and may be connected to the second connecting electrode ELT2 through at least one of the second, third, and/or fourth light emitting elements LD2, LD3, and/or LD4 and fifth and fourth connecting electrodes ELT5 and ELT4.

The fourth connecting electrode ELT4 may be located on the second area (for example, the lower area) of the second electrode ALE2 and the second end portions EP2 of the third light emitting elements LD3 to be electrically connected to the second end portions EP2 of the third light emitting elements LD3. In addition, the fourth connecting electrode ELT4 may be located on the second area (for example, the upper area) of the fourth electrode ALE4 and the first end portions EP1 of the fourth light emitting elements LD4 to be electrically connected to the first end portions EP1 of the fourth light emitting elements LD4. For example, the fourth connecting electrode ELT4 may connect the second end portions EP2 of the third light emitting elements LD3 and the first end portions EP1 of the fourth light emitting elements LD4 in the light emitting area EA. For this, the fourth connecting electrode ELT4 may have a curved shape. For example, the fourth connecting electrode ELT4 may have a curved or bent structure at a boundary between an area in which at least one third light emitting element LD3 is arranged and an area in which at least one fourth light emitting element LD4 is arranged.

In addition, the fourth connecting electrode ELT4 may be electrically connected between the first and second connecting electrodes ELT1 and ELT2 through the light emitting elements LD. For example, the fourth connecting electrode ELT4 may be connected to the first connecting electrode ELT1 through at least one of the first, second, and/or third light emitting elements LD1, LD2, and LD3, and the fifth and third connecting electrodes ELT5 and ELT3, and may be connected to the second connecting electrode ELT2 through at least one fourth light emitting element LD4.

The fifth connecting electrode ELT5 may be located on the second area (for example, the lower area) of the third electrode ALE3 and the second end portions EP2 of the second light emitting elements LD2 to be electrically connected to the second end portions EP2 of the second light emitting elements LD2. In addition, the fifth connecting electrode ELT5 may be located on the second area (for example, the lower area) of the fourth electrode ALE4 and the first end portions EP1 of the third light emitting elements LD3 to be electrically connected to the first end portions EP1 of the third light emitting elements LD3. For example, the fifth connecting electrode ELT5 may connect the second end portions EP2 of the second light emitting elements LD2 and the first end portions EP1 of the third light emitting elements LD3 in the light emitting area EA. For this, the fifth connecting electrode ELT5 may have a curved shape. For example, the fifth connecting electrode ELT5 may have a curved or bent structure at or around a boundary between an area in which at least one second light emitting element LD2 is arranged and an area in which at least one third light emitting element LD3 is arranged. In one or more embodiments, the fifth connecting electrode ELT5 does not extend to the separating area SPA and may be formed only inside the light emitting area EA, but embodiments are not limited necessarily thereto.

In addition, the fifth connecting electrode ELT5 may be electrically connected between the first and second connecting electrodes ELT1 and ELT2 through the light emitting elements LD. For example, the fifth connecting electrode ELT5 may be electrically connected to the first connecting electrode ELT1 through at least one of the first and second light emitting elements LD1 and LD2 and third connecting electrode ELT3, and may be electrically connected to the second connecting electrode ELT2 through at least one of the third and/or fourth light emitting elements LD3 and/or LD4 and fourth connecting electrode ELT4.

In one or more embodiments, each of the connecting electrodes ELT may extend from the light emitting area EA through the non-light emitting area NEA to the separating area SPA, and may be electrically connected to at least one electrode ALE through a contact hole CH in the separating area SPA. For example, the first to fourth connecting electrodes ELT1 to ELT4 may extend from the light emitting area EA to the first separating area SPA1. In the first separating area SPA1, the first connecting electrode ELT1 may be electrically connected to the first electrode ALE1 through the first contact hole CH1, and the second connecting electrode ELT2 may be electrically connected to the second electrode ALE2 through the second contact hole CH2. In addition, in the first separating area SPA1, the third connecting electrode ELT3 may be electrically connected to the third electrode ALE3 through the third contact hole CH3, and the fourth connecting electrode ELT4 may be electrically connected to the fourth electrode ALE4 through the fourth contact hole CH4.

Although FIG. 5 illustrates embodiments in which all of the first to fourth connecting electrodes ELT1 to ELT4 extend to the first separating area SPA1, embodiments of the present disclosure are not limited thereto. For example, some or all of the first to fourth connecting electrodes ELT1 to ELT4 may extend to the second separating area SPA2 to be electrically connected to a corresponding electrode ALE in the second separating area SPA2.

As such, when the contact holes CH are located in the separating area SPA, the contact holes CH may be formed in an area excluding the light emitting area EA in which the light emitting elements LD are supplied and aligned, so that in the alignment step of the light emitting elements LD, a more uniform electric field may be formed in the light emitting area EA, and the likelihood of separation of the light emitting elements LD may be reduced or prevented.

According to the above-described manner, the light emitting elements LD arranged between the electrodes ALE and/or the patterns BNP, which may overlap the connecting electrodes ELT, may be connected in a desired connection pattern (e.g., series and/or parallel connection) by using the electrodes ELT. For example, the first light emitting elements LD1, the second light emitting elements LD2, the third light emitting elements LD3, and the fourth light emitting elements LD4 may be sequentially connected in series by using the connecting electrodes ELT.

The bank BNK may be provided in the non-light emitting area NEA to be around (or surround) the light emitting area EA and the separating area SPA. In addition, the bank BNK may be provided at an outer portion of each pixel area PXA and/or between adjacent pixel areas PXA so as to include a plurality of openings OPA corresponding to the light emitting area EA and the separating area SPA of the pixel PXL. For example, the bank BNK may include a first opening OPA1 corresponding to the light emitting area EA, a second opening OPA2 corresponding to the first separating area SPA1, and a third opening OPA3 corresponding to the second separating area SPA2. That is, the bank BNK may include a first opening OPA1 defining the light emitting area EA, a second opening OPA2 defining the first separating area SPA1, and a third opening OPA3 defining the second separating area SPA2.

The bank BNK may form a dam structure that defines the light emitting area EA in which the light emitting elements LD may be supplied in the step of supplying the light emitting elements LD to each pixel PXL. For example, the light emitting area EA is partitioned by the bank BNK, so that a desired type and/or amount of light emitting element ink may be supplied into the light emitting area EA.

The bank BNK may include at least one light blocking and/or reflective material. Accordingly, light leakage between adjacent pixels PXL may be reduced or prevented. For example, the bank BNK may include at least one of a black matrix material and/or a color filter material. For example, the bank BNK may be formed in a black opaque pattern that may block transmission of light. In one or more embodiments, a reflective film may be formed on a surface (for example, a side wall) of the bank BNK to increase the light efficiency of each pixel PXL.

Hereinafter, a cross-sectional structure of each pixel PXL will be described in detail with reference to FIG. 6 - FIG. 8, based on the light emitting element LD. FIG. 6 and FIG. 7 illustrate the second transistor M2 among various circuit elements forming the pixel circuit PXC, and FIG. 7 illustrates the first transistor M1. Hereinafter, when it is not necessary to distinguish and specify the first transistor M1 and the second transistor M2, they will be comprehensively referred to as the "transistor M." However, structures of the transistors M and/or a position of each layer thereof are not limited to the embodiments shown in FIG. 6 and FIG. 7, and may be variously changed according to embodiments.

Referring to FIG. 6 and FIG. 7, the pixels PXL according to one or more embodiments and the display panel PNL including the pixels PXL may include a circuit layer PCL and a display layer DPL that are located on one surface of a substrate SUB.

Circuit elements (for example, the transistors M and the storage capacitor Cst) configuring the pixel circuit PXC of the corresponding pixel PXL and various wires connected to the circuit elements may be located in the circuit layer PCL. The electrodes ALE, the light emitting elements LD, and/or the connecting electrodes ELT that configure the light emitting part EMU of the corresponding pixel PXL may be located in the display layer DPL.

For example, the substrate SUB configures a base member, and may be a rigid or flexible substrate or film. For example, the substrate SUB may be a hard substrate made of glass or tempered glass, a flexible substrate (or a thin film) made of a plastic or metallic material, or at least one layered insulating layer. The material and/or physical properties of the substrate SUB of embodiments are not particularly limited. In one or more embodiments, the substrate SUB may be substantially transparent. Here, "substantially transparent" may mean that light may be transmitted at a desired transmittance (e.g., a set or predetermined transmittance) or more. In one or more embodiments, the substrate SUB may be translucent or opaque. In addition, the substrate SUB may include a reflective material according to one or more embodiments.

The transistor M may be located on the substrate SUB. The transistor M includes a semiconductor pattern SCP, a gate electrode GE, and first and second transistor electrodes TE1 and TE2, and may selectively further include a bottom metal layer BML.

The bottom metal layer BML may be located on the substrate SUB. The bottom metal layer BML may overlap the gate electrode GE and/or the semiconductor pattern SCP of at least one transistor M (for example, the first transistor M1) in the Z-axis direction.

A buffer layer BFL may be located on the bottom metal layer BML and the substrate SUB. The buffer layer BFL may reduce or prevent impurities diffusing into each circuit element. The buffer layer BFL may be formed as a single layer, but may also be formed as a multilayer of at least two layers or more. When the buffer layer BFL is formed as the multilayer, respective layers may be made of the same material or different materials.

The semiconductor pattern SCP may be located on the buffer layer BFL. For example, the semiconductor pattern SCP may include a first area contacting the first transistor electrode TE1, a second area contacting the second transistor electrode TE2, and a channel area located between the first and second areas that overlaps the gate electrode GE of the transistor M (for example, the first transistor M1) in the Z-axis direction. In one or more embodiments, one of the first and second areas may be a source area, and the other one may be a drain area.

In one or more embodiments, the semiconductor pattern SCP may be made of polysilicon, amorphous silicon, an oxide semiconductor, or the like. In addition, the channel area of the semiconductor pattern SCP may be an intrinsic semiconductor as a semiconductor pattern that is not doped with impurities, and each of the first and second areas of the semiconductor pattern SCP may be a semiconductor doped with suitable impurities (e.g., a set or predetermined impurities).

A gate insulating layer GI may be located on the semiconductor pattern SCP and the buffer layer BFL. For example, the gate insulating layer GI may be located between the semiconductor pattern SCP and the gate electrode GE. The gate insulating layer GI may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

The gate electrode GE may be located on the gate insulating layer Gl. The gate electrode GE may be located to overlap the semiconductor pattern SCP in the third direction (Z-axis direction) on the gate insulating layer Gl.

A first interlayer insulating layer ILD1 may be located on the gate electrode GE and the gate insulating layer Gl. For example, the first interlayer insulating layer ILD1 may be located between the gate electrode GE and the first and second transistor electrodes TE1 and TE2. The first interlayer insulating layer ILD1 may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

The first and second transistor electrodes TE1 and TE2 may be located on the first interlayer insulating layer ILD1. The first and second transistor electrodes TE1 and TE2 may be located to overlap the semiconductor pattern SCP in the third direction (Z-axis direction). The first and second transistor electrodes TE1 and TE2 may be electrically connected to the semiconductor pattern SCP. For example, the first transistor electrode TE1 may be electrically connected to a first area of the semiconductor pattern SCP through a contact hole penetrating the first interlayer insulating layer ILD1 and the gate insulating layer Gl. The second transistor electrode TE2 may be electrically connected to a second area of the semiconductor pattern SCP through a contact hole penetrating the first interlayer insulating layer ILD1 and the gate insulating layer Gl. In one or more embodiments, one of the first and second transistor electrodes TE1 and TE2 may be a source electrode, and the other one may be a drain electrode.

A second interlayer insulating layer ILD2 may be located on the first and second electrodes TE1 and TE2 and the first interlayer insulating layer ILD1. The second interlayer insulating layer ILD2 may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

A bridge pattern BRP and/or the second power line PL2 may be located on the second interlayer insulating layer ILD2. The bridge pattern BRP may be electrically connected to the first transistor electrode TE1 through a contact hole penetrating the second interlayer insulating layer ILD2. The bridge pattern BRP and the second power line PL2 may be formed of the same conductive layer. That is, the bridge pattern BRP and the second power line PL2 may be concurrently formed (e.g., substantially simultaneously formed) in the same process, but embodiments are not limited thereto.

The passivation layer PSV may be located on circuit elements including the transistors M. The passivation layer PSV may be made of an organic material in order to flatten a lower step thereof. For example, the passivation layer PSV may include an organic material such as an acrylates resin, an epoxy resin, a phenolic resin, a polyamides resin, a polyimides resin, a polyesters resin, a polyphenylenesulfides resin, or a benzocyclobutene (BCB). However, embodiments are not necessarily limited thereto, and the passivation layer PSV may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

The display layer DPL may be located on the passivation layer PSV of the circuit layer PCL. The display layer DPL may include patterns BNP, electrodes ALE, light emitting elements LD, first insulating pattern INP1, second insulating pattern INP2, and connecting electrodes ELT.

The patterns BNP may be located on the passivation layer PSV. The patterns BNP may have various shapes according to embodiments. In one or more embodiments, the patterns BNP may have a shape protruding in the third direction (Z-axis direction) on the substrate SUB. In addition, the patterns BNP may be formed to have an inclined surface inclined at a suitable angle (e.g., a set or predetermined angle) with respect to the substrate SUB. However, embodiments of the present disclosure are not necessarily limited thereto, and the patterns BNP may have a side wall having a curved surface or a step shape. For example, the patterns BNP may have a cross-section of a semicircle or semi-ellipse shape.

Electrodes and insulating layers located at an upper portion of the patterns BNP may have a shape corresponding to the patterns BNP. As an example, the electrodes ALE located on the patterns BNP may include an inclined surface or a curved surface having a shape corresponding to the shape of the patterns BNP. Accordingly, the patterns BNP, along with the electrodes ALE provided thereon, may function as a reflective member that guides the light emitted from the light emitting elements LD in a front direction of the pixel PXL (Z-axis direction) to improve the light emitting efficiency of the display panel PNL.

The patterns BNP may include at least one organic material and/or inorganic material. For example, the patterns BNP may include an organic material such as an acrylates resin, an epoxy resin, a phenolic resin, a polyamides resin, a polyimides rein , a polyesters resin, a polyphenylenesulfides resin, or a benzocyclobutene (BCB). However, embodiments are not necessarily limited thereto, and the patterns BNP may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

The electrodes ALE may be located on the passivation layer PSV and the patterns BNP. The electrodes ALE may be located to be spaced apart each other in the light emitting area EA. As described above, the electrodes ALE may receive an alignment signal in the alignment step of the light emitting elements LD. Accordingly, an electric field is formed between the electrodes ALE so that the light emitting elements LD supplied to each pixel PXL may be aligned between the electrodes ALE.

In one or more embodiments, each of the electrodes ALE may have a pattern separated for each pixel PXL, or may have a pattern commonly connected to adjacent pixels PXL. For example, each of the first to fourth electrodes ALE1 to ALE4 may have an independent pattern with both ends cut off in the separating area SPA located at the outer periphery of the corresponding pixel area PXA. Alternatively, at least one electrode (for example, the first electrode ALE1) may have an independent pattern of which both ends are cut in the separating area SPA, and at least one other electrode (for example, the second electrode ALE2) may extend in the first direction (X-axis direction) or the second direction (Y-axis direction) to be integrally connected to an electrode (e.g., a set or predetermined electrode) of other adjacent pixels PXL (for example, the second electrode ALE2 of the adjacent pixel PXL).

The first electrode ALE1 may be electrically connected to the bridge pattern BRP through the first contact portion CNT1 penetrating the passivation layer PSV, and through this, may be electrically connected to the transistor M. The second electrode ALE2 may be electrically connected to the second power line PL2 through the second contact portion CNT2 penetrating the passivation layer PSV.

Each of the electrodes ALE may include at least one conductive material. For example, each of the electrodes ALE may include at least one metal of various metal materials including silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), and copper (Cu), or an alloy including the same; a conductive oxide such as an indium tin oxide (ITO), an indium zinc oxide (IZO), an indium tin zinc Oxide (ITZO), a zinc oxide (ZnO), an aluminum zinc oxide (AZO), a gallium zinc oxide (GZO), a zinc tin oxide (ZTO), a gallium tin oxide (GTO), or a fluorine tin oxide (FTO); and at least one conductive material among conductive polymers such as PEDOT, but embodiments are not necessarily limited thereto.

An insulating layer INS may be located on the electrodes ALE. The insulating layer INS may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

The bank BNK may be located on the insulating layer INS of the non-light emitting area NEA. For example, the bank BNK may be provided in the non-light emitting area NEA to be around (or surround or partially surround) the light emitting area EA and the separating area SPA.

The bank BNK may be located to overlap the first and/or second contact portions CNT1 and CNT2. For example, the bank BNK may be located to cover the first and second contact portions CNT1 and CNT2. However, embodiments of the present disclosure are not necessarily limited thereto, and the bank BNK may be located to non-overlap the first and second contact portion CNT1 and CNT2.

In one or more embodiments, the bank BNK may be located to non-overlap the contact holes CH. Accordingly, it is possible to easily connect respective electrodes ALE to respective connecting electrodes ELT after the formation of the bank BNK.

The bank BNK may include at least one organic material and/or inorganic material. For example, the bank BNK may include an organic material such as an acrylates resin, an epoxy resin, a phenolic resin, a polyamides resin, a polyimides rein , a polyesters resin, a polyphenylenesulfides resin, or a benzocyclobutene (BCB). However, embodiments are not necessarily limited thereto, and the bank BNK may be configured as a single layer or multilayer, and may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic materials.

The light emitting elements LD may be located on the insulating layer INS of the light emitting area EA. The light emitting elements LD may be located between the electrodes ALE on the insulating layer INS. The light emitting elements LD may be prepared in a form dispersed in a suitable solution (e.g., a set or predetermined solution, such as ink), and may be supplied to each pixel PXL through an inkjet printing method and the like. For example, the light emitting elements LD may be dispersed in a volatile solvent to be provided in the light emitting area of each pixel PXL. In the process of aligning the light emitting elements LD, when an alignment signal is supplied through the electrodes ALE, as an electric field is formed between the electrodes ALE, the light emitting elements LD may be aligned between the electrodes ALE. After the light emitting elements LD are aligned, the light emitting elements LD may be stably arranged between the electrodes ALE by volatilizing the solvent or eliminating it in other ways.

The first insulating pattern INP1 and the second insulating pattern INP2 are located on the light emitting elements LD. The first insulating pattern INP1 and the second insulating pattern INP2 will be described in detail with reference to FIG. 8. In FIG. 8, for better understanding and ease of description, the first and second insulating patterns INP1 and INP2 will be described based on the first light emitting element LD1.

Referring to FIG. 8, the first insulating pattern INP1 is partially located on the light emitting elements LD. The first insulating pattern INP1 is located on the light emitting elements LD, and may expose the first and second end portions EP1 and EP2 of the light emitting elements LD.

The first insulating pattern INP1 may serve to reduce or prevent a residual film from being formed on the first and second end portions EP1 and EP2 of the light emitting elements LD in a process of forming a concavo-convex structure by etching the second insulating pattern INP2, which will be described later. In addition, when the first insulating pattern INP1 is formed on the light emitting elements LD after the alignment of the light emitting elements LD is completed, it is possible to reduce or prevent the likelihood of a light emitting elements LD deviating from an aligned position.

The first insulating pattern INP1 may include at least one inorganic material and/or organic material. For example, the first insulating pattern INP1 may include a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx), and various types of inorganic insulating materials. However, embodiments are not necessarily limited thereto, the first insulating pattern INP1 may include an organic insulating material such as an acrylates resin, an epoxy resin, a phenolic resin, a polyamides resin, a polyimides rein , a polyesters resin, a polyphenylenesulfides resin, or a benzocyclobutene (BCB).

The second insulating pattern INP2 is located on the first insulating pattern INP1. The second insulating pattern INP2 may be directly located on the first insulating pattern INP1 to contact an upper surface of the first insulating pattern INP1.

The second insulating pattern INP2 includes a plurality of first inorganic layers IOL1 and second inorganic layers IOL2 that are different from each other. The first inorganic layer IOL1 and the second inorganic layer IOL2 may be alternately stacked. The first inorganic layer IOL1 and the second inorganic layer IOL2 may include different inorganic materials. For example, each of the first inorganic layer IOL1 and the second inorganic layer IOL2 may include at least one of a silicon oxide (SiOx), a silicon nitride (SiNx), a silicon oxynitride (SiOxNy), a silicon oxycarbide (SiOxCy), a silicon carbonitride (SiCxNy), an aluminum oxide (AlOx), an aluminum nitride (AlNx), a hafnium oxide (HfOx), a zirconium oxide (ZrOx), a titanium oxide (TiOx), and a tantalum oxide (TaOx), but embodiments are not limited thereto.

A width W1 in the first direction (X-axis direction) of the first inorganic layer IOL1 and a width W2 in the first direction (X-axis direction) of the second inorganic layer IOL2 may be different from each other. In one or more embodiments, the width W1 in the first direction (X-axis direction) of the first inorganic layer IOL1 may be larger than the width W2 in the first direction (X-axis direction) of the second inorganic layer IOL2. For example, when the first inorganic layer IOL1 is a silicon oxide (SiOx) and the second inorganic layer IOL2 is a silicon nitride (SiNx), due to a difference in etching selectivity between the first inorganic layer IOL1 and the second inorganic layer IOL2 in the process of forming the second insulating pattern INP2, the width W1 of the first inorganic layer IOL1 in the first direction (X-axis direction) may be larger than the width W2 of the second inorganic layer IOL2 in the first direction (X-axis direction). However, the materials included in the first inorganic layer IOL1 and the second inorganic layer IOL2 of embodiments are not necessarily limited thereto, and may be variously changed within a range capable of selectively etching the second inorganic layer IOL2. As described above, when the first inorganic layer IOL1 and the second inorganic layer IOL2 having different widths are alternately stacked, a side surface of the second insulating pattern INP2 may have a concavo-convex shape. Accordingly, when the connecting electrodes ELT are formed on the second insulating pattern INP2, the connecting electrodes ELT may be naturally separated from the side surface of the second insulating pattern INP2 due to the concavo-convex shape of the second insulating pattern INP2. That is, even if the connecting electrodes ELT are concurrently formed (e.g., substantially simultaneously formed), the connecting electrodes ELT may be separated by the second insulating pattern INP2, so that the likelihood of a short circuit between the connecting electrodes ELT may be reduced or prevented.

The width W1 in the first direction (X-axis direction) of the first inorganic layer IOL1 and/or the width W2 in the first direction (X-axis direction) of the second inorganic layer IOL2 may be smaller than a width WL in the first direction (X-axis direction) of the light emitting elements LD. In this case, the second insulating pattern INP2 may not overlap the first and second end portions EP1 and EP2 of the light emitting elements LD in the third direction (Z-axis direction). That is, the first and second end portions EP1 and EP2 of the light emitting elements LD may be exposed by the second insulating pattern INP2. Accordingly, the connecting electrodes ELT, which will be described later, may be naturally separated by the second insulating pattern INP2 to be formed on the first and second end portions EP1 and EP2 of the light emitting elements LD exposed by the insulating patterns INP1 and INP2.

The connecting electrodes ELT may be located on the first and second end portions EP1 and EP2 of the light emitting elements LD exposed by the insulating patterns INP1 and INP2. Each of the connecting electrodes ELT may be made of various transparent conductive materials. For example, the connecting electrodes ELT may include at least one of various transparent materials such as an indium tin oxide (ITO), an indium zinc oxide (IZO), an indium tin zinc oxide (ITZO), a zinc oxide (ZnO), an aluminum zinc oxide (AZO), a gallium zinc oxide (GZO), a zinc tin oxide (ZTO), a gallium tin oxide (GTO), or a fluorine tin oxide (FTO), and they may be implemented to be substantially transparent or translucent to satisfy a desired transmittance (e.g., a set or predetermined transmittance). Accordingly, the light emitted from the first and second end portions EP1 and EP2 of the light emitting elements LD may pass through the connecting electrodes ELT to be emitted to the outside of the display panel PNL.

The connecting electrodes ELT may be located at the same layer, as shown in FIG. 6 and the like. That is, the connecting electrodes ELT may be formed of the same conductive layer. In this case, the connecting electrodes ELT may be concurrently formed (e.g., substantially simultaneously formed) at the same process. As described above, because the connecting electrodes ELT may be naturally separated and formed at the same time by using the concave-convex structure of the side surface of the second insulating pattern INP2, it is possible to reduce the number of masks to simplify the manufacturing process of the display device.

Each of the connecting electrodes ELT may be electrically connected to at least one of the electrodes ALE through the contact hole CH penetrating the insulating layer INS located therebelow. For example, the first connecting electrode ELT1 may be electrically connected to the first electrode ALE1 through the first contact hole CH1 penetrating the insulating layer INS. The second connecting electrode ELT2 may be electrically connected to the second electrode ALE2 through the second contact hole CH2 penetrating the insulating layer INS. The third connecting electrode ELT3 may be electrically connected to the third electrode ALE3 through the third contact hole CH3 penetrating the insulating layer INS. The fourth connecting electrode ELT4 may be electrically connected to the fourth electrode ALE4 through the fourth contact hole CH4 penetrating the insulating layer INS.

In one or more embodiments, the connecting electrodes ELT may contact the side surface of the first insulating pattern INP1. For example, as shown in FIG. 8, the first connecting electrode ELT1 contacting the first end portion EP1 of the first light emitting elements LD1 may contact one side of the first insulating pattern INP1, and the third connecting electrode ELT3 contacting the second end portion EP2 of the first light emitting elements LD1 may contact the other side of the first insulating pattern INP1.

In one or more embodiments, a conductive pattern CP may be located on the side surface of the second insulating pattern INP2. In one or more embodiments, the conductive pattern CP may be formed of the same conductive layer as the connecting electrodes ELT. That is, the conductive pattern CP may be made of the same material as that of the connecting electrodes ELT. The conductive pattern CP may be concurrently formed (e.g., substantially simultaneously formed) in the same process as the connecting electrodes ELT. In this case, the conductive pattern CP may be naturally separated from the connecting electrodes ELT due to the concavo-convex shape on the side surface of the second insulating pattern INP2 to remain on the side surface of the second insulating pattern INP2. For example, as shown in FIG. 8, the conductive pattern CP may be partially located on the side surface of the first inorganic layer IOL1 due to the concavo-convex shape of the second insulating pattern INP2. The conductive pattern CP may be directly located on the side surface of the first inorganic layer IOL1 to contact the side surface of the first inorganic layer IOL1. In this case, the conductive pattern CP may not contact the side surface of the second inorganic layer IOL2.

The conductive pattern CP may include the same material as the connecting electrodes ELT. For example, the conductive pattern CP may be made of various transparent conductive materials. For example, the conductive pattern CP may include at least one of various transparent materials such as an indium tin oxide (ITO), an indium zinc oxide (IZO), an indium tin zinc oxide (ITZO), a zinc oxide (ZnO), an aluminum zinc oxide (AZO), a gallium zinc oxide (GZO), a zinc tin oxide (ZTO), a gallium tin oxide (GTO), or a fluorine tin oxide (FTO).

According to the above-described embodiments, because the connecting electrodes ELT may be naturally separated by the side protrusions and depressions of the second insulating pattern INP2, the likelihood of a short circuit between the connecting electrodes ELT may be reduced or prevented even if the connecting electrodes ELT are concurrently formed (e.g., substantially simultaneously formed). Accordingly, it is possible to reduce the number of masks and simplify a manufacturing process of a display device.

Subsequently, a manufacturing method of the display device according to the above-described embodiments will be described.

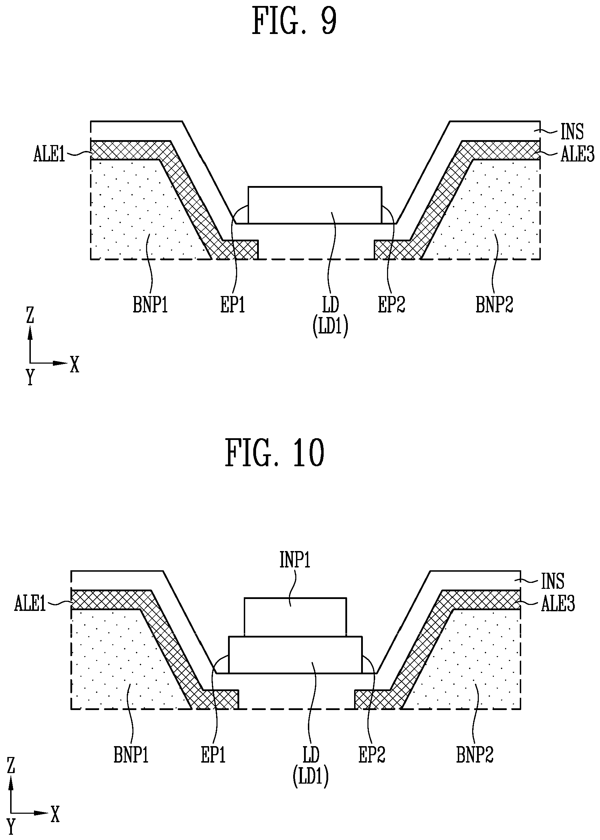

FIG. 9 - FIG. 13 illustrate cross-sectional views of process steps of a manufacturing method of a display device according to one or more embodiments. FIG. 9 - FIG. 13 are cross-sectional views for explaining the manufacturing method of the display device of FIG. 8, and constituent elements that are substantially the same as those of FIG. 8 are denoted by the same reference numerals, and detailed descriptions thereof will be omitted.

Referring to FIG. 9, first, the electrodes ALE that are spaced from each other are formed. An insulating layer INS may be formed on the electrodes ALE and at a space between the electrodes ALE. The light emitting elements LD may be supplied and aligned between the electrodes ALE that are spaced from each other. The light emitting elements LD may be located on the insulating layer INS. For example, the first and third electrodes ALE1 and ALE3 may receive a first alignment signal (or first alignment voltage) and a second alignment signal (or second alignment voltage), respectively, in an alignment step of the light emitting elements LD. For example, one of the first and third electrodes ALE1 and ALE3 may be supplied with an AC-type alignment signal, and the other one of the first and third electrodes ALE1 and ALE3 may be supplied with an alignment voltage (for example, a ground voltage) having a constant voltage level. The light emitting elements LD are supplied to the light emitting area of each pixel PXL through an inkjet method, a slit coating method, or various other methods, and they may be aligned with directionality between the electrodes ALE by a suitable alignment signal (.g.., a predetermined alignment signal) (or alignment voltage) applied to each of the electrodes ALE.

Referring to FIG. 10, subsequently, the first insulating pattern INP1 is formed on the light emitting elements LD. The first insulating pattern INP1 may be partially formed on the light emitting elements LD to expose the first and second end portions EP1 and EP2 of the light emitting elements LD.

The first insulating pattern INP1 may be made of various types of inorganic insulating materials including a silicon oxide (SiOx), a silicon nitride (SiNx), a silicon oxynitride (SiOxNy), an aluminum nitride (AlNx), an aluminum oxide (AlOx), a zirconium oxide (ZrOx), a hafnium oxide (HfOx), or a titanium oxide (TiOx). However, embodiments are not necessarily limited thereto, the first insulating pattern INP1 may be made of an organic insulating material such as an acrylates resin, an epoxy resin, a phenolic resin, a polyamides resin, a polyimides rein , a polyesters resin, a polyphenylenesulfides resin, or a benzocyclobutene (BCB).

Referring to FIG. 11, next, the second insulating pattern INP2 is formed on the first insulating pattern INP1. The second insulating pattern INP2 is formed by alternately depositing the first inorganic layers IOL1 and the second inorganic layers IOL2 and then etching them. In the process of etching the first and second inorganic layers IOL1 and IOL2, the protrusions and depressions on the side surface of the second insulating pattern INP2 are implemented by using the difference in the etching selectivity between the first inorganic layer IOL1 and the second inorganic layer IOL2. For example, when the first inorganic layer IOL1 is made of a silicon oxide (SiOx) and the second inorganic layer IOL2 is made of a silicon nitride (SiNx), due to the difference in the etch selectivity between the first inorganic layer IOL1 and the second inorganic layer IOL2, the second inorganic layer IOL2 may be etched faster than the first inorganic layer IOL1. Accordingly, the width W1 of the first direction (X-axis direction) of the first inorganic layer IOL1 is larger than the width W2 of the first direction (X-axis direction) of the second inorganic layer IOL2. However, the materials included in the first inorganic layer IOL1 and the second inorganic layer IOL2 of embodiments are not necessarily limited thereto, and they may be variously changed within a range capable of implementing the concave-convex shape of the side surface of the second insulating pattern INP2 by using the difference in the etch selectivity between the first inorganic layer IOL1 and the second inorganic layer IOL2.

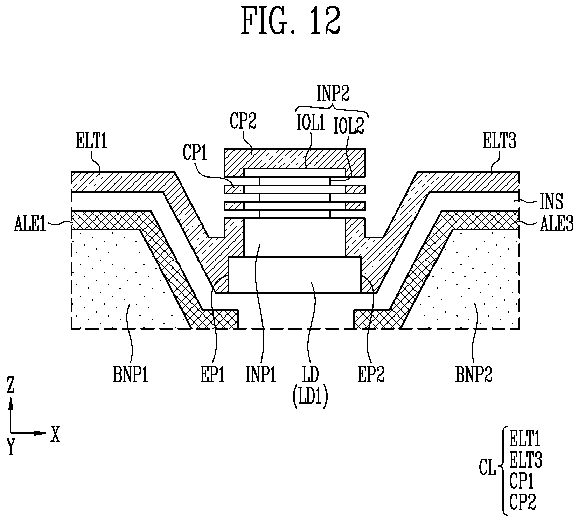

Referring to FIG. 12, subsequently, the connecting electrode layer CL is formed on the light emitting elements LD, the insulating layer INS, and the first and second insulating patterns INP1 and INP2. The connecting electrode layer CL may disconnected by the concavo-convex structure of the second insulating pattern INP2 to be divided into the first connecting electrode ELT1, the third connecting electrode ELT3, the first conductive pattern CP1, and the second conductive pattern CP2. For example, as the side surface of the second insulating pattern INP2 is formed to have the concavo-convex structure, the connecting electrode layer CL may be disconnected on the side surface of the second insulating pattern INP2 to be divided into the first connecting electrode ELT1, the third connecting electrode ELT3, the first conductive pattern CP1, and the second conductive pattern CP2. For example, the first connecting electrode ELT1 may be formed on the first end portions EP1 of the first light emitting elements LD1, the third connecting electrode ELT3 may be formed on the second end portions EP2 of the first light emitting elements LD1, the first conductive pattern CP1 may be formed on the side surfaces of the first inorganic layers IOL1 of the second insulating pattern INP2, and the second conductive pattern CP2 may be formed on the upper surface of the second insulating pattern INP2.

As described above, when the connecting electrode layer CL is naturally separated by the concavo-convex structure on the side surface of the second insulating pattern INP2, even if the connecting electrodes ELT are concurrently formed (e.g., substantially simultaneously formed), the likelihood of a short circuit between the connecting electrodes ELT may be reduced or prevented by the second insulating pattern INP2. Therefore, as described above, the number of masks may be reduced, and the manufacturing process of the display device may be simplified.

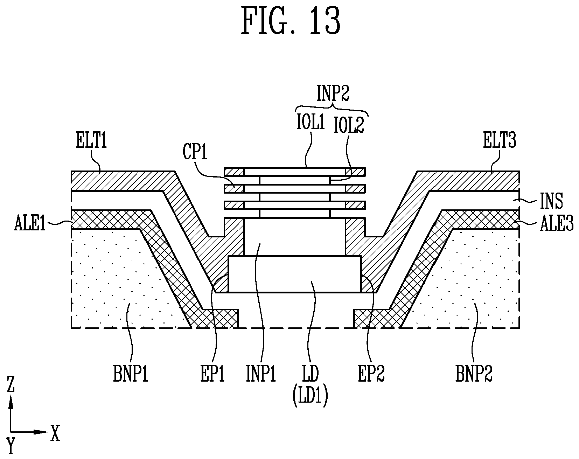

Referring to FIG. 13, subsequently, the second conductive pattern CP2 is etched and removed. The etching process may be performed by wet etching, but embodiments are not limited thereto. As described above, in the process of separating the connecting electrodes ELT, when the second conductive pattern CP2 formed or remaining on the upper surface of the second insulating pattern INP2 is removed, it is possible to more effectively reduce or prevent the likelihood of the connecting electrodes ELT being short-circuited.

As discussed, embodiments can provide a display device as defined by claim 1.

The display device may comprise pixels. Each pixel may comprise the first and second electrodes, and the first and second connecting electrodes. In some embodiments, each pixel comprises first to fourth electrodes. These electrodes may be alignment electrodes for light emitting elements of the pixel.

The light emitting element may be over the first electrode and the second electrode.

The first connecting electrode may have a portion that is over the first electrode, and the second connecting electrode may have a portion that is over the second electrode.

The first connecting electrode may have a portion that extends from the first end of the light emitting element to a first side of the first insulating pattern. The second connecting electrode may have a portion that extends from the second end of the light emitting element to a second side of the first insulating pattern.

Embodiments can provide a manufacturing method of a display device as defined by claim 11.

## Claims

1. A display device comprising:
a first electrode (ALE1) and a second electrode (ALE3) that are spaced from each other along a first direction (X) and are each extending along a second direction (Y) perpendicular to the first direction;
a light emitting element (LD) between the first electrode (ALE1) and the second electrode (ALE3);
a first connecting electrode (ELT1) contacting the first electrode (ALE1) and a first end of the light emitting element (LD);
a second connecting electrode (ELT3) contacting the second electrode (ALE3) and a second end of the light emitting element (LD);
a first insulating pattern (INP1) between the first connecting electrode (ELT1) and the second connecting electrode (ELT3) over the light emitting element; and
a second insulating pattern (INP2)
**characterised in that**
the second insulating pattern (INP2)
comprising first inorganic layers (IOL1)
and second inorganic layers (IOL2) that are alternately stacked with each other between the first connecting electrode (ELT1) and the second connecting electrode (ELT3) over the first insulating pattern (INP1), and wherein the first inorganic layer (IOL1) and the second inorganic layer (IOL2) have different etch selectivities to an etching process used to form the second insulating layer (INP2), and
wherein a width in the first direction of a first inorganic layer of the first inorganic layers (IOL1) is greater than a width in the first direction of a second inorganic layer of the second inorganic layers (IOL2).

2. The display device of claim 1, wherein the width of the first inorganic layer (IOL1) is less than a width of the light emitting element (LD).

3. The display device of claim 2, wherein the first inorganic layer (IOL1) comprises silicon oxide, and
wherein the second inorganic layer (IOL2) comprises silicon nitride.

4. The display device of claim 3, further comprising a conductive pattern (CP) on a side surface of the first inorganic layer.

5. The display device of claim 4, wherein the conductive pattern (CP) does not contact the second inorganic layer.

6. The display device of claim 5, wherein the conductive pattern (CP) is separated from the first connecting electrode (ELT1) and the second connecting electrode (ELT3).

7. The display device of claim 6, wherein the conductive pattern (CP) comprises a same material as the first connecting electrode (ELT1) and the second connecting electrode (ELT3).

8. The display device of claim 7, wherein the first connecting electrode (ELT1) contacts a first side of the first insulating pattern, and
wherein the second connecting electrode (ELT2) contacts a second side of the first insulating pattern.

9. The display device of claim 8, wherein the first insulating pattern exposes the first end and the second end of the light emitting element;
optionally wherein the first insulating pattern comprises an inorganic insulating material or wherein the first insulating pattern comprises an organic insulating material.

10. The display device of any one of claims 1 to 9, wherein the first connecting electrode (ELT1) and the second connecting electrode (ELT2) comprise a same material;
optionally wherein the first connecting electrode (ELT1) and the second connecting electrode (ELT2) are at a same layer.

11. A manufacturing method of a display device, comprising:
forming a first electrode (ALE1) and a second electrode (ALE3) that are spaced from each other along a first direction (X) and are each extending along a second direction (Y) perpendicular to the first direction;
aligning a light emitting element (LD) between the first electrode (ALE3) and the second electrode (ALE3);
forming a first insulating pattern (INP1) on the light emitting element;
forming a second insulating pattern (INP2) comprising first inorganic layers (IOL1) and second inorganic layers (IOL2) that are alternately stacked with each other, and etching them; and
forming, on the light emitting element (LD), a connecting electrode layer comprising a first connecting electrode (ELT1) on a first end of the light emitting element and a second connecting electrode (ELT2) on a second end of the light emitting element, the first connecting electrode and the second connecting electrode being separated by the second insulating pattern, and
wherein, in the forming of the second insulating pattern (INP2), the second inorganic layers are etched more quickly than the first inorganic layers.

12. The manufacturing method of the display device of claim 11, wherein the connecting electrode layer further comprises a first conductive pattern (CP1) on a side surface of a first inorganic layer of the first inorganic layers.

13. The manufacturing method of the display device of claim 12, wherein the connecting electrode layer further comprises a second conductive pattern (CP2) on the second insulating pattern;
optionally wherein the first connecting electrode, the second connecting electrode, the first conductive pattern, and the second conductive pattern are concurrently formed by a same process;
optionally further comprising removing the second conductive pattern.

## Patentansprüche

1. Anzeigevorrichtung, umfassend:
eine erste Elektrode (ALE1) und eine zweite Elektrode (ALE3), die entlang einer ersten Richtung (X) voneinander beabstandet sind und sich jeweils entlang einer zweiten Richtung (Y) senkrecht zu der ersten Richtung erstrecken;
ein lichtemittierendes Element (LD) zwischen der ersten Elektrode (ALE1) und der zweiten Elektrode (ALE3);
eine erste Verbindungselektrode (ELT1), welche die erste Elektrode (ALE1) und ein erstes Ende des lichtemittierenden Elements (LD) kontaktiert;
eine zweite Verbindungselektrode (ELT3), welche die zweite Elektrode (ALE3) und ein zweites Ende des lichtemittierenden Elements (LD) kontaktiert;
ein erstes Isoliermuster (INP1) zwischen der ersten Verbindungselektrode (ELT1) und der zweiten Verbindungselektrode (ELT3) über dem lichtemittierenden Element; und
ein zweites Isoliermuster (INP2),
**dadurch gekennzeichnet, dass**
das zweite Isoliermuster (INP2) erste anorganische Schichten (IOL1) und zweite anorganische Schichten (IOL2) umfasst, die abwechselnd zwischen der ersten Verbindungselektrode (ELT1) und der zweiten Verbindungselektrode (ELT3) über dem ersten Isoliermuster (INP1) miteinander gestapelt sind, und wobei die erste anorganische Schicht (IOL1) und die zweite anorganische Schicht (IOL2) andere Ätzselektivitäten als ein Ätzprozess aufweisen, der verwendet wird, um die zweite Isolierschicht (INP2) zu bilden, und
wobei eine Breite in der ersten Richtung einer ersten anorganischen Schicht der ersten anorganischen Schichten (IOL1) größer als eine Breite in der ersten Richtung einer zweiten anorganischen Schicht der zweiten anorganischen Schichten (IOL2) ist.

2. Anzeigevorrichtung nach Anspruch 1, wobei die Breite der ersten anorganischen Schicht (IOL1) weniger als eine Breite des lichtemittierenden Elements (LD) ist.

3. Anzeigevorrichtung nach Anspruch 2, wobei die erste anorganische Schicht (IOL1) Siliziumoxid umfasst, und
wobei die zweite anorganische Schicht (IOL2) Siliziumnitrid umfasst.

4. Anzeigevorrichtung nach Anspruch 3, ferner umfassend ein leitendes Muster (CP) auf einer Seitenfläche der ersten anorganischen Schicht.

5. Anzeigevorrichtung nach Anspruch 4, wobei das leitende Muster (CP) die zweite anorganische Schicht nicht kontaktiert.

6. Anzeigevorrichtung nach Anspruch 5, wobei das leitende Muster (CP) von der ersten Verbindungselektrode (ELT1) und der zweiten Verbindungselektrode (ELT3) getrennt ist.

7. Anzeigevorrichtung nach Anspruch 6, wobei das leitende Muster (CP) ein gleiches Material wie die erste Verbindungselektrode (ELT1) und die zweite Verbindungselektrode (ELT3) umfasst.

8. Anzeigevorrichtung nach Anspruch 7, wobei die erste Verbindungselektrode (ELT1) eine erste Seite des ersten Isoliermusters kontaktiert, und
wobei die zweite Verbindungselektrode (ELT2) eine zweite Seite des ersten Isoliermusters kontaktiert.

9. Anzeigevorrichtung nach Anspruch 8, wobei das erste Isoliermuster das erste Ende und das zweite Ende des lichtemittierenden Elements freilegt;
wobei optional das erste Isoliermuster ein anorganisches Isoliermaterial umfasst oder wobei das erste Isoliermuster ein organisches Isoliermaterial umfasst.

10. Anzeigevorrichtung nach einem der Ansprüche 1 bis 9, wobei die erste Verbindungselektrode (ELT1) und die zweite Verbindungselektrode (ELT2) ein gleiches Material umfassen;
wobei optional die erste Verbindungselektrode (ELT1) und die zweite Verbindungselektrode (ELT2) auf einer gleichen Schicht sind.

11. Herstellungsverfahren für eine Anzeigevorrichtung, umfassend:
Bilden einer ersten Elektrode (ALE1) und einer zweiten Elektrode (ALE3), die entlang einer ersten Richtung (X) voneinander beabstandet sind und sich jeweils entlang einer zweiten Richtung (Y) senkrecht zu der ersten Richtung erstrecken;
Ausrichten eines lichtemittierenden Elements (LD) zwischen der ersten Elektrode (ALE3) und der zweiten Elektrode (ALE3);
Bilden eines ersten Isoliermusters (INP1) auf dem lichtemittierenden Element;
Bilden eines zweiten Isoliermusters (INP2), das erste anorganische Schichten (IOL1) und zweite anorganische Schichten (IOL2) umfasst, die abwechselnd miteinander gestapelt sind, und Ätzen derselben; und
Bilden, auf dem lichtemittierenden Element (LD), einer Verbindungselektrodenschicht, die eine erste Verbindungselektrode (ELT1) an einem ersten Ende des lichtemittierenden Elements und eine zweite Verbindungselektrode (ELT2) an einem zweiten Ende des lichtemittierenden Elements umfasst, wobei die erste Verbindungselektrode und die zweite Verbindungselektrode durch das zweite Isoliermuster getrennt sind, und
wobei bei dem Bilden des zweiten Isoliermusters (INP2) die zweiten anorganischen Schichten schneller als die ersten anorganischen Schichten geätzt werden.

12. Herstellungsverfahren für die Anzeigevorrichtung nach Anspruch 11, wobei die Verbindungselektrodenschicht ferner ein erstes leitendes Muster (CP1) auf einer Seitenfläche einer ersten anorganischen Schicht der ersten anorganischen Schichten umfasst.

13. Herstellungsverfahren für die Anzeigevorrichtung nach Anspruch 12, wobei die Verbindungselektrodenschicht ferner ein zweites leitendes Muster (CP2) auf dem zweiten Isoliermuster umfasst;
wobei optional die erste Verbindungselektrode, die zweite Verbindungselektrode, das erste leitende Muster und das zweite leitende Muster gleichzeitig durch einen gleichen Prozess gebildet werden;
optional ferner umfassend Entfernen des zweiten leitenden Musters.

## Revendications

1. Afficheur comprenant :
une première électrode (ALE1) et une seconde électrode (ALE3) qui sont espacées l'une de l'autre le long d'une première direction (X) et s'étendent chacune le long d'une seconde direction (Y) perpendiculaire à la première direction ;
un élément électroluminescent (LD) entre la première électrode (ALE1) et la seconde électrode (ALE3) ;
une première électrode de connexion (ELT1) en contact avec la première électrode (ALE1) et une première extrémité de l'élément électroluminescent (LD) ;
une seconde électrode de connexion (ELT3) en contact avec la seconde électrode (ALE3) et une seconde extrémité de l'élément électroluminescent (LD) ;
un premier motif isolant (INP1) entre la première électrode de connexion (ELT1) et la seconde électrode de connexion (ELT3) sur l'élément électroluminescent ; et
un second motif isolant (INP2)
**caractérisé en ce que**
le second motif isolant (INP2)
comprend des premières couches inorganiques (IOL1) et des secondes couches inorganiques (IOL2) qui sont empilées alternativement entre la première électrode de connexion (ELT1) et la seconde électrode de connexion (ELT3) sur le premier motif isolant (INP1), et ladite première couche inorganique (IOL1) et ladite seconde couche inorganique (IOL2) comportant des sélectivités de gravure différentes à un processus de gravure utilisé pour former la seconde couche isolante (INP2), et
une largeur dans la première direction d'une première couche inorganique des premières couches inorganiques (IOL1) étant supérieure à une largeur dans la première direction d'une seconde couche inorganique des secondes couches inorganiques (IOL2).

2. Afficheur de la revendication 1, ladite largeur de la première couche inorganique (IOL1) étant inférieure à une largeur de l'élément électroluminescent (LD).

3. Afficheur de la revendication 2, ladite première couche inorganique (IOL1) comprenant de l'oxyde de silicium, et
ladite seconde couche inorganique (IOL2) comprenant du nitrure de silicium.

4. Afficheur de la revendication 3, comprenant en outre un motif conducteur (CP) sur une surface latérale de la première couche inorganique.

5. Afficheur de la revendication 4, ledit motif conducteur (CP) n'étant pas en contact avec la seconde couche inorganique.

6. Afficheur de la revendication 5, ledit motif conducteur (CP) étant séparé de la première électrode de connexion (ELT1) et de la seconde électrode de connexion (ELT3).

7. Afficheur de la revendication 6, ledit motif conducteur (CP) comprenant le même matériau que la première électrode de connexion (ELT1) et la seconde électrode de connexion (ELT3).

8. Afficheur de la revendication 7, ladite première électrode de connexion (ELT1) étant en contact avec un premier côté du premier motif isolant, et
ladite seconde électrode de connexion (ELT2) étant en contact avec un second côté du premier motif isolant.

9. Afficheur de la revendication 8, ledit premier motif isolant exposant la première extrémité et la seconde extrémité de l'élément électroluminescent ;
éventuellement, ledit premier motif isolant comprenant un matériau isolant inorganique ou ledit premier motif isolant comprenant un matériau isolant organique.

10. Afficheur de l'une quelconque des revendications 1 à 9, ladite première électrode de connexion (ELT1) et ladite seconde électrode de connexion (ELT2) comprenant un même matériau ;
éventuellement, ladite première électrode de connexion (ELT1) et ladite seconde électrode de connexion (ELT2) étant au niveau d'une même couche.

11. Procédé de fabrication d'un afficheur comprenant :
la formation d'une première électrode (ALE1) et d'une seconde électrode (ALE3) qui sont espacées l'une de l'autre le long d'une première direction (X) et s'étendent chacune le long d'une seconde direction (Y) perpendiculaire à la première direction ;
l'alignement d'un élément électroluminescent (LD) entre la première électrode (ALE3) et la seconde électrode (ALE3) ;
la formation d'un premier motif isolant (INP1) sur l'élément électroluminescent ;
la formation d'un second motif isolant (INP2) comprenant des premières couches inorganiques (IOL1) et des secondes couches inorganiques (IOL2) qui sont empilées alternativement les unes avec les autres, et la gravure de celles-ci ; et
la formation, sur l'élément électroluminescent (LD), d'une couche d'électrode de connexion comprenant une première électrode de connexion (ELT1) sur une première extrémité de l'élément électroluminescent et une seconde électrode de connexion (ELT2) sur une seconde extrémité de l'élément électroluminescent, la première électrode de connexion et la seconde électrode de connexion étant séparées par le second motif isolant, et
lors de la formation du second motif isolant (INP2), lesdites secondes couches inorganiques étant gravées plus rapidement que les premières couches inorganiques.

12. Procédé de fabrication de l'afficheur de la revendication 11, ladite couche d'électrode de connexion comprenant en outre un premier motif conducteur (CP1) sur une surface latérale d'une première couche inorganique des premières couches inorganiques.

13. Procédé de fabrication de l'afficheur de la revendication 12, ladite couche d'électrode de connexion comprenant en outre un second motif conducteur (CP2) sur le second motif isolant ;
éventuellement, ladite première électrode de connexion, ladite seconde électrode de connexion, ledit premier motif conducteur et ledit second motif conducteur étant formés simultanément par un même processus ;
éventuellement, comprenant en outre le retrait du second motif conducteur.
